# EUROPEAN PATENT APPLICATION

(11) **EP 4 436 339 A2**
(43) Date of publication of application: **25.09.2024**
(21) Application number: 24165324.5
(22) Date of filing: 21.03.2024
(51) Int. Cl.: H10K 59/121, H10K 59/131

(54) **DISPLAY APPARATUS**

(30) Priority: 24.03.2023 KR 20230039050; 28.07.2023 KR 20230099002
(71) Applicant: Samsung Display Co., Ltd., Yongin-si, Gyeonggi-do 17113 (KR)
(72) Inventor: LEE, Wonse, 17113 Yongin-si (KR); LEE, Jieun, 17113 Yongin-si (KR); LEE, Sujin, 17113 Yongin-si (KR); JANG, Donghyeon, 17113 Yongin-si (KR)
(74) Representative: Marks & Clerk LLP

(57) **Abstract**

A display apparatus includes: a substrate including a first area (MDA), a second area (CA), and a third area (MA) between the first area (MDA) and the second area (CA); first light-emitting diodes (EDm) in the first area (MDA); first sub-pixel circuits (PCm) in the first area (MDA) and respectively and electrically connected to the first light-emitting diodes (EDm); second light-emitting diodes (EDa) in the second area (CA); second sub-pixel circuits (PCa) in the second area (CA) and respectively and electrically connected to the second light-emitting diodes (EDa); third light-emitting diodes (EDn) in the third area (MA); and a connection line (CNL) electrically connecting a sub-pixel electrode (210) of each of the third light-emitting diodes (EDn) to a sub-pixel electrode (210) of each of the first light-emitting diodes (EDm).

## Description

### BACKGROUND

### 1. Field

Aspects of one or more embodiments relate to a display apparatus.

### 2. Description of the Related Art

Generally, a display apparatus includes a display element and electronic elements for controlling electrical signals applied to the display element. The electronic elements may include one or more thin-film transistors (TFTs), one or more capacitors, and a plurality of wirings.

Recently, the various uses of display apparatuses has become more diversified. In addition, as display apparatuses have become relatively thinner and more lightweight, their range of uses has gradually expanded. As the range of uses of display apparatuses has expanded, various methods have been studied in designing display apparatuses.

The above information disclosed in this Background section is only for enhancement of understanding of the background and therefore the information discussed in this Background section does not necessarily constitute prior art.

### SUMMARY

Aspects of one or more embodiments include a display apparatus in which a brightness deviation around a component area is relatively improved. However, such a characteristic is merely an example, and embodiments according to the present disclosure are not limited thereto.

Additional aspects and characteristics will be set forth in part in the description which follows and, in part, will be apparent from the description, or may be learned by practice of the presented embodiments of the disclosure.

According to one or more embodiments, a display apparatus includes a substrate including a first area, a second area, and a third area between the first area and the second area, first light-emitting diodes arranged in the first area, first sub-pixel circuits arranged in the first area and respectively and electrically connected to the first light-emitting diodes, second light-emitting diodes arranged in the second area, second sub-pixel circuits arranged in the second area and respectively and electrically connected to the second light-emitting diodes, third light-emitting diodes arranged in the third area, and a connection line electrically connecting a sub-pixel electrode of each of the third light-emitting diodes to a sub-pixel electrode of each of the first light-emitting diodes.

According to some embodiments, the first light-emitting diodes, the second light-emitting diodes, and the third light-emitting diodes may respectively include light-emitting diodes of a first color, light-emitting diodes of a second color, and light-emitting diodes of a third color, and the connection line may electrically connect a sub-pixel electrode of a third light-emitting diode of a first color to a sub-pixel electrode of a first light-emitting diode of a first color.

According to some embodiments, the third light-emitting diode of the first color may have a same size as the first light-emitting diode of the first color.

According to some embodiments, the display apparatus may further include a horizontal conductive line extending in a first direction, wherein the horizontal conductive line may include a first horizontal conductive line spaced apart from the second area in a second direction crossing the first direction, and a second horizontal conductive line including a first portion and a second portion spaced apart from each other with the second area therebetween, and wherein the connection line may extend in the first direction and be arranged in a same row as the second horizontal conductive line.

According to some embodiments, the connection line may be arranged between the first portion of the second horizontal conductive line and the second area, or between the second portion of the second horizontal conductive line and the second area.

According to some embodiments, the horizontal conductive line may be electrically connected to an opposite electrode of the first light-emitting diode.

According to some embodiments, the display apparatus may further include a vertical conductive line extending in a second direction, wherein the vertical conductive line may include a first vertical conductive line spaced apart from the second area in a first direction crossing the second direction, and a second vertical conductive line including a first portion and a second portion spaced apart from each other with the second area therebetween, and wherein the connection line may extend in the second direction and be arranged in a same column as the second vertical conductive line.

According to some embodiments, the connection line may extend in the second direction and be arranged between the first portion of the second vertical conductive line and the second area, or between the second portion of the second vertical conductive line and the second area.

According to some embodiments, the vertical conductive line may be electrically connected to an opposite electrode of the first light-emitting diode.

According to some embodiments, the horizontal conductive line may include a first sub-portion and a second sub-portion, and the second sub-portion of the horizontal conductive line may be on a layer different from a layer on which the first sub-portion is located.

According to some embodiments, the connection line may include a first portion and a second portion on different layers, wherein the first portion of the connection line may include a same material as the first sub-portion of the horizontal conductive line, and wherein the second portion of the connection line may include a same material as the second sub-portion of the horizontal conductive line.

According to some embodiments, the first sub-pixel circuit may include a first transistor including a first semiconductor layer and a first gate electrode overlapping a channel region of the first semiconductor layer, and a first electrode overlapping and electrically connected to one of a source region and a drain region of the first semiconductor layer.

According to some embodiments, the first portion of the connection line may include a same material as the first electrode.

According to some embodiments, the display apparatus may further include a first insulating layer covering the first electrode, and a second electrode on the first insulating layer and electrically connecting the first electrode to a sub-pixel electrode of the first light-emitting diode.

According to some embodiments, the second portion of the connection line may include a same material as the second electrode.

According to some embodiments, the connection line may further include a third portion on a layer different from the first portion and the second portion, and the third portion of the connection line may include a same material as a sub-pixel electrode of the first light-emitting diode.

According to some embodiments, the first sub-pixel circuit may further include a second transistor including a second semiconductor layer and a second gate electrode overlapping the second semiconductor layer, wherein the first semiconductor layer of the first transistor may include a silicon semiconductor material, and wherein the second semiconductor layer of the second transistor may include an oxide semiconductor material.

According to some embodiments, the second area may include a transmission area.

According to some embodiments, the display apparatus may further include a component overlapping the second area.

According to some embodiments, the component may include a camera or a sensor.

At least some of the above and other features of the invention are set out in the claims.

### BRIEF DESCRIPTION OF THE DRAWINGS

The above and other aspects, features, and characteristics of certain embodiments of embodiments according to the present disclosure will be more apparent from the following description taken in conjunction with the accompanying drawings, in which:
FIG. 1 is a schematic plan view of a display apparatus according to some embodiments;
FIG. 2 is a cross-sectional view of the display apparatus, taken along the line I-I' of FIG. 1;
FIG. 3 is a schematic plan view of a display panel according to some embodiments;
FIG. 4 is a plan view of a horizontal common voltage line and a vertical common voltage line of a display panel according to some embodiments;
FIG. 5 is a schematic equivalent circuit diagram of a sub-pixel circuit electrically connected to a light-emitting diode of a display panel according to some embodiments;
FIGS. 6A and 6B are schematic plan views of a partial region of a display panel according to some embodiments;
FIGS. 7A and 7B are enlarged plan views of a portion of a display panel according to some embodiments;
FIGS. 8A and 8B are plan views of a horizontal conductive line and a vertical conductive line passing near a component area of a display panel according to some embodiments;
FIG. 9 is a schematic plan view of positions of elements arranged in a region of a sub-pixel circuit according to some embodiments;
FIG. 10 is a cross-sectional view of the sub-pixel circuit, taken along the line A-A' of FIG. 9;
FIGS. 11A to 11I are schematic arrangement views of elements of FIG. 9, for each layer according to some embodiments;
FIG. 12 is a schematic plan view of a portion of a main display area and an intermediate area according to some embodiments;
FIG. 13 is a cross-sectional view of the main display area and the intermediate area, taken along the line E-E' of FIG. 12 according to some embodiments;
FIG. 14 is an enlarged plan view of some layers of a region D of FIG. 12 according to some embodiments;
FIG. 15 is a cross-sectional view of the main display area and the intermediate area, taken along the line F-F' of FIG. 12 according to some embodiments;
FIG. 16 is a schematic plan view of a portion of the main display area and the intermediate area according to some embodiments;
FIG. 17 is a cross-sectional view of the main display area and the intermediate area, taken along the line H-H' of FIG. 16 according to some embodiments; and
FIG. 18 is a cross-sectional view of the main display area and the intermediate area, taken along the line J-J' of FIG. 16 according to some embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or any combination of a, b, and/or c.

As the disclosure allows for various changes and numerous embodiments, certain embodiments will be illustrated in the drawings and described in the written description. Effects and features of the disclosure, and methods for achieving them will be clarified with reference to embodiments described below in detail with reference to the drawings. However, embodiments according to the present disclosure are not limited to the following embodiments and may be embodied in various forms.

While such terms as "first" and "second" may be used to describe various elements, such elements must not be limited to the above terms. The above terms are used to distinguish one element from another.

The singular forms "a," "an," and "the" as used herein are intended to include the plural forms as well unless the context clearly indicates otherwise.

It will be understood that the terms "comprise," "comprising," "include" and/or "including" as used herein specify the presence of stated features or elements but do not preclude the addition of one or more other features or elements.

It will be further understood that, when a layer, region, or element is referred to as being "on" another layer, region, or element, it can be directly or indirectly on the other layer, region, or element. That is, for example, intervening layers, regions, or elements may be present.

In the present specification, "A and/or B" means A or B, or A and B. In the present specification, "at least one of A and B" means A or B, or A and B.

As used herein, when a wiring is referred to as "extending in a first direction or a second direction," it means that the wiring not only extends in a straight line shape but also extends in a zigzag or in a curve in the first direction or the second direction.

As used herein, "on a plan view" means that an objective portion is viewed from above, and "on a cross-sectional view" means that a cross-section of an objective portion taken vertically is viewed from a lateral side. As used herein, "overlapping" includes overlapping "in a plan view" and "in a cross-sectional view."

Hereinafter, embodiments of the present disclosure are described in more detail with reference to the accompanying drawings. When description is made with reference to the drawings, like reference numerals are used for like or corresponding elements.

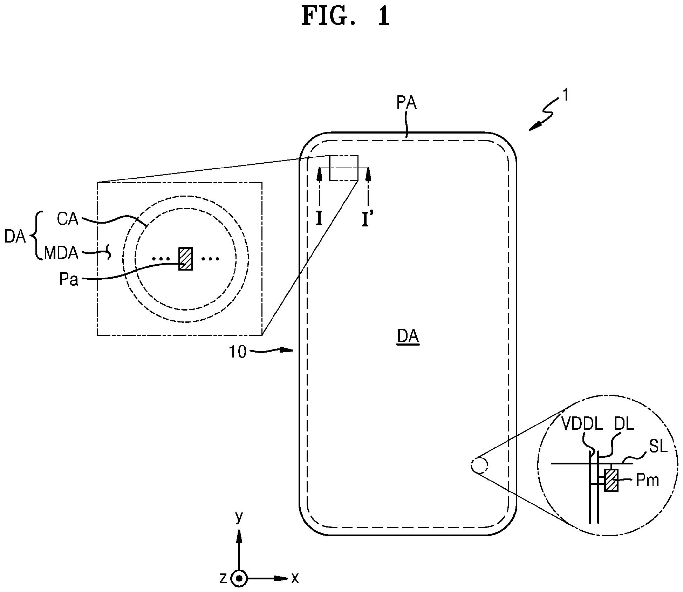

FIG. 1 is a schematic plan view of a display apparatus 1 according to some embodiments.

The display apparatus 1 according to some embodiments includes a display panel 10. As long as the display apparatus includes the display panel 10, any display apparatus may be used. As an example, the display apparatus may include various products such as smartphones, tablet computers, laptop computers, televisions, advertisement boards, or the like.

The display panel 10 includes a display area DA and a peripheral area PA outside (e.g., in a periphery or outside a footprint of) the display area DA. The display area DA is a portion configured to display images, and a plurality of sub-pixels may be arranged in the display area DA. When viewed in a direction (e.g., a -z direction) approximately perpendicular to the display panel 10 (e.g., in a plan view), the display area DA may have various shapes such as a circular shape, an elliptical shape, a polygon, and a shape of a specific figure. It is shown in FIG. 1 that the display area DA has an approximately rectangular shape having round corners, but embodiments according to the present disclosure are not limited thereto.

The peripheral area PA may be arranged outside the display area DA. The peripheral area PA may be a non-display area at which images are not displayed.

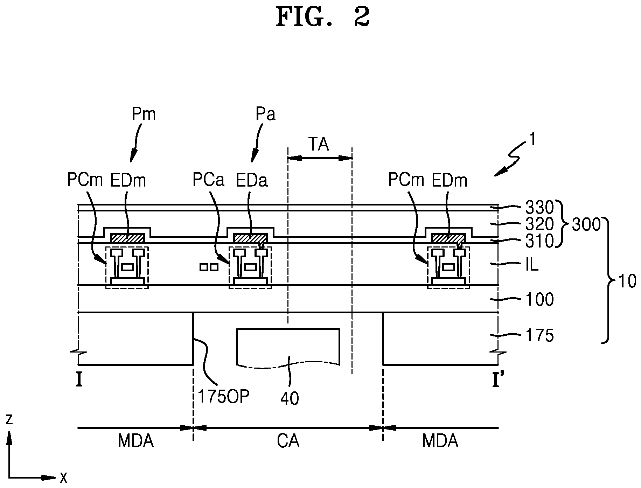

Because the display panel 10 includes a substrate 100 (see FIG. 2) described below, it may be considered that the substrate 100 includes the display area DA and the peripheral area PA. Hereinafter, for convenience, description is made on the assumption that the substrate 100 includes the display area DA and the peripheral area PA.

Hereinafter, although an organic light-emitting display apparatus is described as an example of the display apparatus 1 according to some embodiments, the display apparatus is not limited thereto. According to some embodiments, the display apparatus 1 according to some embodiments may be an inorganic light-emitting display apparatus or a quantum-dot light-emitting display apparatus. As an example, an emission layer of a light-emitting element of the display apparatus 1 may include an organic material or an inorganic material. In addition, the display apparatus 1 may include an emission layer and a quantum-dot layer located on a path of light emitted from the emission layer.

The display area DA may include a main display area MDA. The main display area MDA may occupy most of the area of the display area DA. When the main display area MDA occupies most of the area of the display area DA, it refers to the area of the main display area MDA being 50% or more of the area of the display area DA.

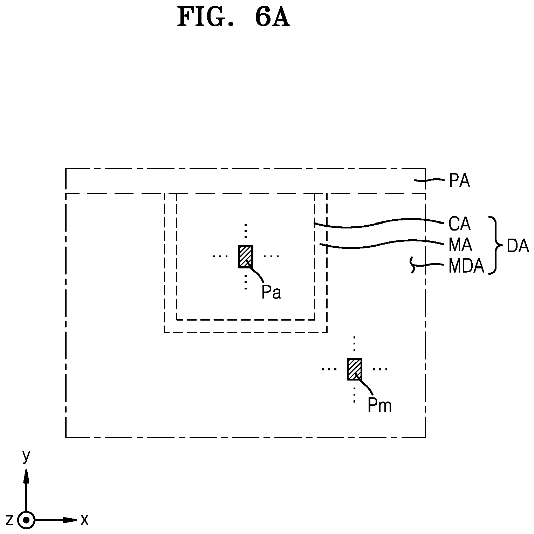

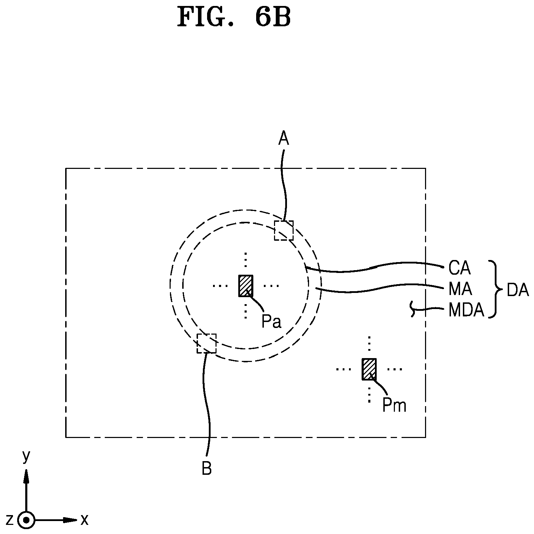

The display area DA may include a component area CA, which is a region below which a component 40 (see FIG. 2) including an optical element and the like is located. The component area CA is arranged inside the main display area MDA and at least partially surrounded by the main display area MDA. According to some embodiments, the main display area MDA may be a first region, and the component area CA may be a second area. The display area DA may further include an intermediate area MA (see FIGS. 6A and 6B) between the main display area MDA and the component area CA.

The display area DA may be configured to display images by using a plurality of sub-pixels arranged two-dimensionally. Each sub-pixel may include a light-emitting element such as an organic light-emitting diode. The sub-pixel may be configured to emit, for example, red, green, or blue light.

In the present specification, among the sub-pixels arranged in the display area DA, sub-pixels arranged in the main display area MDA are referred to as first sub-pixels Pm, and sub-pixels arranged in the component area CA are referred to as second sub-pixels Pa.

FIG. 2 is a schematic cross-sectional view of the display apparatus 1, taken along the line I-I' of FIG. 1, according to some embodiments.

Referring to FIG. 2, the display apparatus 1 may include the display panel 10 and the component 40, wherein the component 40 is located below the display panel 10 and arranged to correspond to the component area CA.

The component 40 may be an electronic element that uses light or sound. As an example, the electronic element may be a sensor that measures a distance such as a proximity sensor, a sensor that recognizes a portion of a user's body (e.g., a fingerprint, an iris, a face and the like), a small lamp that outputs light, or an image sensor (e.g., a camera) that photographs images. The electronic element that uses light may use light in various wavelength bands such as visible light, infrared light, ultraviolet light, and the like. The electronic element that uses sound may use ultrasonic waves or sound in different frequency bands.

The component area CA may be a region in which the component 40 is arranged. The component area CA may include a transmission area TA through which light and/or sound that is output from the component 40 to the outside or that progresses toward the component 40 from the outside may pass. According to some embodiments, a light transmittance of the component area CA may be 30% or more, more preferably, 50% or more, 75% or more, 80% or more, 85% or more, or 90% or more.

The component area CA may include the transmission area TA having a light transmittance of a preset numerical value, and the transmission area TA may be the remaining area of the component area CA excluding the area where the second sub-pixels Pa are arranged. The number of second sub-pixels Pa arranged in the component area CA may be less than the number of first sub-pixels Pm arranged in the main display area MDA. Images displayed in the component area CA may have a resolution less than images displayed in the main display area MDA.

The display panel 10 may include the substrate 100, an insulating layer IL, the first sub-pixels Pm, the second sub-pixels Pa, an encapsulation layer 300, and a lower protective film 175.

The substrate 100 may include glass or a polymer resin. The polymer resin may include polyethersulfone, polyacrylate, polyetherimide, polyethylene naphthalate, polyethylene terephthalate, polyphenylene sulfide, polyarylate, polyimide, polycarbonate, or cellulose acetate propionate. The substrate 100 including the polymer resin may be flexible, rollable, or bendable. The substrate 100 may have a multi-layered structure including a layer that includes the polymer resin and an inorganic layer.

The first sub-pixel Pm and the second sub-pixel Pa may be configured to emit light using a light-emitting diode. With regard to this, in the present specification, a light-emitting diode corresponding to the first sub-pixel Pm and arranged in the main display area MDA is referred to as a first light-emitting diode EDm, and a light-emitting diode corresponding to the second sub-pixel Pa and arranged in the component area CA is referred to as a second light-emitting diode EDa. The first and second light-emitting diodes EDm and EDa may be arranged over the substrate 100.

The first light-emitting diode EDm is arranged in the main display area MDA and electrically connected to a first sub-pixel circuit PCm arranged in the main display area MDA. The first sub-pixel circuit PCm may include transistors and a capacitor electrically connected to the transistors. The insulating layer IL may be located between elements such as the transistors and the capacitor.

The second light-emitting diode EDa may be arranged in the component area CA and electrically connected to the second sub-pixel circuit PCa arranged in the component area CA. The second sub-pixel circuit PCa may include transistors and a capacitor electrically connected to the transistors. The insulating layer IL may be located between elements such as the transistors and the capacitor.

In addition, the transmission area TA in which the second light-emitting diode EDa or the second sub-pixel circuit PCa is not arranged may be arranged in the component area CA. It may be understood that that transmission area TA is a region through which light/signal emitted from the component 40 or light/signal incident to the component 40 is transmitted.

The first and second light-emitting diodes EDm and EDa may be covered by the encapsulation layer 300. According to some embodiments, the encapsulation layer 300 may include at least one inorganic encapsulation layer and at least one organic encapsulation layer. The encapsulation layer 300 may include first and second inorganic encapsulation layers 310 and 330, and the organic encapsulation layer 320 therebetween. According to some embodiments, the encapsulation layer 300 may be an encapsulation substrate such as glass. Sealant such as frit and the like may be located between the substrate 100 and the encapsulation substrate.

The first and second inorganic encapsulation layers 310 and 330 may include an inorganic insulating material including aluminium oxide, titanium oxide, tantalum oxide, hafnium oxide, zinc oxide, silicon oxide, silicon nitride, silicon oxynitride, and the like. The organic encapsulation layer 320 may include a polymer-based material. The polymer-based material may include an acryl-based resin, an epoxy-based resin, polyimide, and polyethylene.

The lower protective film 175 may be attached under the substrate 100 to support and protect the substrate 100. The lower protective film 175 may include an opening 175OP corresponding to the component area CA. Because the lower protective film 175 includes the opening 175OP, a light transmittance of the transmission area TA may be relatively improved. The lower protective film 175 may include, for example, polyethyleneterephthalate or polyimide.

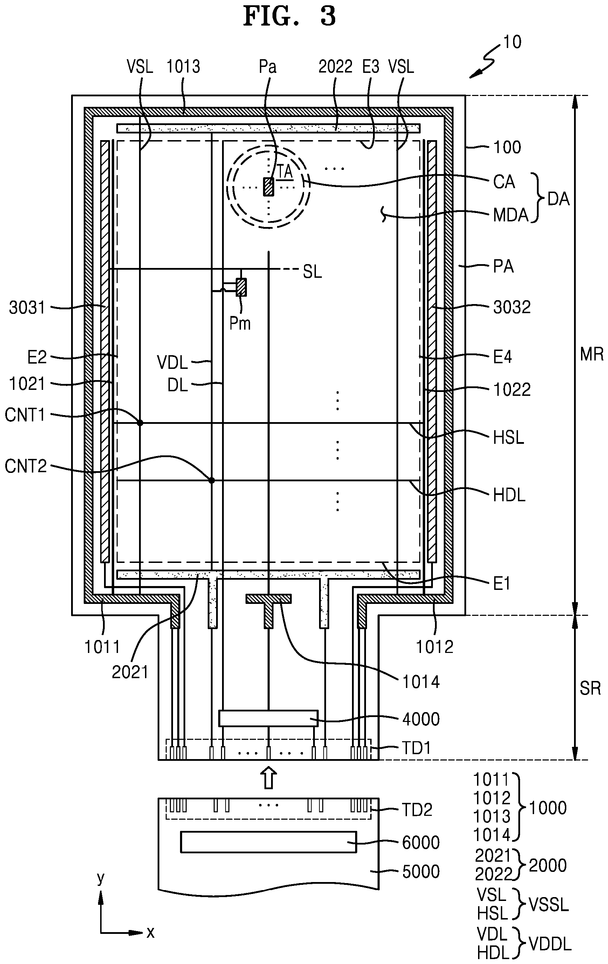

FIG. 3 is a schematic plan view of the display panel 10 according to some embodiments.

Referring to FIG. 3, each of the first sub-pixel circuit PCm (see FIG. 2) included in the first sub-pixel Pm and the second sub-pixel circuit PCa (see FIG. 2) included in the second sub-pixel Pa may include transistors connected to a signal line or a voltage line configured to control on/off of a light-emitting diode corresponding thereto. With regard to this, FIG. 3 shows a scan line SL, a data line DL as signal lines electrically connected to the transistors, a driving voltage line VDDL and a common voltage line VSSL as voltage lines.

The peripheral area PA may surround the display area DA entirely. A portion (referred to as a protrusion peripheral area, hereinafter) of the peripheral area PA may extend in a direction away from the display area DA. In other words, the display panel 10 may include the display area DA, a main region MR, and a sub-region SR, wherein the main region MR includes a portion of the peripheral area PA surrounding the display area DA, and the sub-region SR extends in one direction from the main region MR. The sub-region SR may correspond to the protrusion peripheral area described above. The width (e.g., the width in an x direction) of the sub-region SR may be less than the width (e.g., the width in the x direction) of the main region MR, and a portion of the sub-region SR may be bent toward the rear surface of the substrate 100.

Voltage supply lines and driving circuits may be arranged in the peripheral area PA. With regard to this, FIG. 3 shows that a common voltage supply line 1000, a driving voltage supply line 2000, a first driving circuit 3031, a second driving circuit 3032, and a data driving circuit 4000 are arranged in the peripheral area PA.

The common voltage supply line 1000 may have a loop shape having one open side and partially surrounding the display area DA. The common voltage supply line 1000 may include a first common voltage input part 1011, a second common voltage input part 1012, and a third common voltage input part 1014 adjacent to a first edge E1 of the display area DA. According to some embodiments, the first and second common voltage input parts 1011 and 1012 may be adjacent to the first edge E1 of the display area DA and be spaced apart from each other. The third common voltage input part 1014 may be adjacent to the first edge E1 of the display area DA, and be located between the first and second common voltage input parts 1011 and 1012.

The first common voltage input part 1011 may be connected to the second common voltage input part 1012 by a body part 1013 extending along a second edge E2, a third edge E3, and a fourth edge E4 of the display area DA. In other words, the first common voltage input part 1011, the second common voltage input part 1012, and the body part 1013 may be integrally formed. The common voltage supply line 1000 has a loop shape including an open side, and two opposite sides of the common voltage supply line 1000 may respectively correspond to the first common voltage input part 1011 and the second common voltage input part 1012, and a portion between the first common voltage input part 1011 and the second common voltage input part 1012 may correspond to the body part 1013.

A first auxiliary common voltage supply line 1021 and a second auxiliary common voltage supply line 1022 may be arranged in the peripheral area PA. Each of the first auxiliary common voltage supply line 1021 and the second auxiliary common voltage supply line 1022 may be a kind of branch line extending from the common voltage supply line 1000.

The first auxiliary common voltage supply line 1021 may be electrically connected to the common voltage supply line 1000 and may extend along the second edge E2 of the display area DA. The first auxiliary common voltage supply line 1021 may be located between a first driving circuit 3031 described below and the second edge E2 of the display area DA.

The second auxiliary common voltage supply line 1022 may be electrically connected to the common voltage supply line 1000 and may extend along the fourth edge E4 of the display area DA. The second auxiliary common voltage supply line 1022 may be located between the second driving circuit 3032 described below and the fourth edge E4 of the display area DA. The common voltage supply line 1000, the first auxiliary common voltage supply line 1021, and the second auxiliary common voltage supply line 1022 may each be electrically connected to the common voltage line VSSL passing across the display area DA.

The common voltage line VSSL may include a first common voltage line and a second common voltage line extending to cross each other. As an example, the common voltage lines VSSL may include the first common voltage line extending in the y direction and the second common voltage line extending in the x direction. Hereinafter, for convenience of description, the 'first common voltage line extending in the y direction' is referred to as a vertical common voltage line VSL, and the 'second common voltage line extending in the x direction' is referred to as a horizontal common voltage line HSL.

The vertical common voltage line VSL and the horizontal common voltage line HSL may pass across the display area DA to cross each other. The vertical common voltage line VSL and the horizontal common voltage line HSL may be located on different layers.

The vertical common voltage line VSL may be electrically connected to the common voltage supply line 1000. One end of each of the vertical common voltage lines VSL may be connected to the body part 1013, and another end of each of the vertical common voltage lines VSL may be connected to the first common voltage input part 1011, the second common voltage input part 1012, or the third common voltage input part 1014.

The horizontal common voltage line HSL may be electrically connected to the first auxiliary common voltage supply line 1021 and the second auxiliary common voltage supply line 1022. One end of each of the horizontal common voltage lines HSL may be electrically connected to the first auxiliary common voltage supply line 1021, and another end of each of the horizontal common voltage lines HSL may be electrically connected to the second auxiliary common voltage supply line 1022.

According to some embodiments, the vertical common voltage line VSL may be electrically connected to the horizontal common voltage line HSL through a first contact hole CNT1 defined in at least one insulating layer therebetween. The first contact hole CNT1 for connection between the vertical common voltage line VSL and the horizontal common voltage line HSL may be located in the display area DA. As an example, the first contact hole CNT1 for connection of the vertical common voltage line VSL and the horizontal common voltage line HSL may be arranged in a portion of the display area DA located between the first edge E1 of the display area DA and the component area CA.

The driving voltage supply line 2000 may include first and second driving voltage input parts 2021 and 2022 spaced apart from each other with the display area DA therebetween. The first and second driving voltage input parts 2021 and 2022 may extend substantially in parallel to each other with the display area DA therebetween. The first driving voltage input part 2021 may be adjacent to the first edge E1 of the display area DA, and the second driving voltage input part 2022 may be adjacent to the third edge E3 of the display area DA.

The driving voltage supply line 2000 may be electrically connected to the driving voltage lines VDDL passing across the display area DA. The driving voltage line VDDL may include a first driving voltage line and a second driving voltage line extending to cross each other. As an example, the driving voltage lines VDDL may include a first driving voltage line extending in the y direction and a second driving voltage line extending in the x direction. Hereinafter, for convenience of description, the 'first driving voltage line extending in the y direction' is referred to as a vertical driving voltage line VDL, and the 'second driving voltage line extending in the x direction' is referred to as a horizontal driving voltage line HDL.

The vertical driving voltage line VDL and the horizontal driving voltage line HDL may pass across the display area DA to cross each other. The vertical driving voltage line VDL and the horizontal driving voltage line HDL may be located on different layers, and connected to each other through a second contact hole CNT2 formed in at least one insulating layer located therebetween. The second contact hole CNT2 for connection between the vertical driving voltage line VDL and the horizontal driving voltage line HDL may be located in the display area DA.

The first driving circuit 3031 and the second driving circuit 3032 may be arranged in the peripheral area PA and electrically connected to the scan line SL. According to some embodiments, some of the scan lines SL may be electrically connected to the first driving circuit 3031, and the rest of the scan lines SL may be connected to the second driving circuit 3032. The first and second driving circuits 3031 and 3032 may include a scan driver configured to generate scan signals. The generated scan signals may be transferred to one of the transistors of the sub-pixel circuit through the scan line SL.

The data driving circuit 4000 may be configured to transfer a data signal to one of the transistors of each sub-pixel circuit through the data line DL passing across the display area DA.

A first terminal part TD1 may be located on one side of the substrate 100. A printed circuit board 5000 may be attached to the first terminal part TD1. The printed circuit board 5000 may include a second terminal part TD2 electrically connected to the first terminal part TD1. A controller 6000 may be located on the printed circuit board 5000. Control signals of the controller 6000 may be provided to each of the first and second driving circuits 3031 and 3032, the data driving circuit 4000, the driving voltage supply line 2000, and the common voltage supply line 1000 through the first and second terminal parts TD1 and TD2.

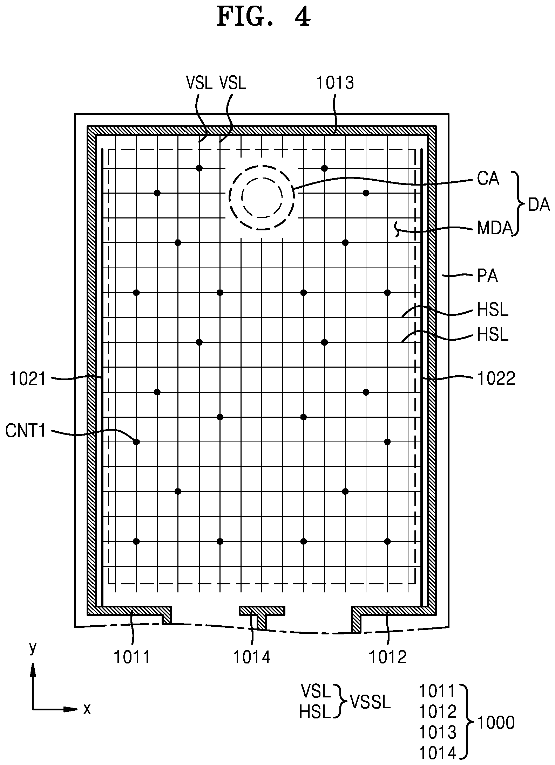

FIG. 4 is a plan view of a horizontal common voltage line and a vertical common voltage line of a display panel according to some embodiments.

Referring to FIG. 4, the common voltage supply line 1000, and the first auxiliary common voltage supply line 1021 and a second auxiliary common voltage supply line 1022 each electrically connected to the common voltage supply line 1000 may be arranged in the peripheral area PA.

The common voltage line VSSL electrically connected to the common voltage supply line 1000 is arranged in the display area DA. The common voltage line VSSL may be electrically connected to an opposite electrode (e.g., a cathode) of a light-emitting diode. The common voltage line VSSL may include vertical common voltage lines VSL and horizontal common voltage lines HSL crossing each other. The vertical common voltage lines VSL extending in the y direction and the horizontal common voltage lines HSL extending in the x direction to cross the vertical common voltage lines VSL may be arranged in the display area DA. Some of the vertical common voltage lines VSL may be electrically connected to the first common voltage input part 1011 and the body part 1013, others may be electrically connected to the second common voltage input part 1012 and the body part 1013, and others may be electrically connected to the third common voltage input part 1014 and the body part 1013.

The vertical common voltage lines VSL and the horizontal common voltage lines HSL crossing each other may have a mesh structure in a plan view. The vertical common voltage lines VSL and the horizontal common voltage lines HSL located on different layers may be electrically connected to each other in a display area. As an example, the vertical common voltage lines VSL and the horizontal common voltage lines HSL may be electrically connected to each other through a first contact hole CNT1 defined in at least one insulating layer located between the vertical common voltage lines VSL and the horizontal common voltage lines HSL.

According to some embodiments, in the case where the display area DA includes the component area CA including the transmission area TA (see FIG. 1), to sufficiently secure the transmission area TA, the vertical common voltage lines VSL and the horizontal common voltage lines HSL may not pass across the component area CA.

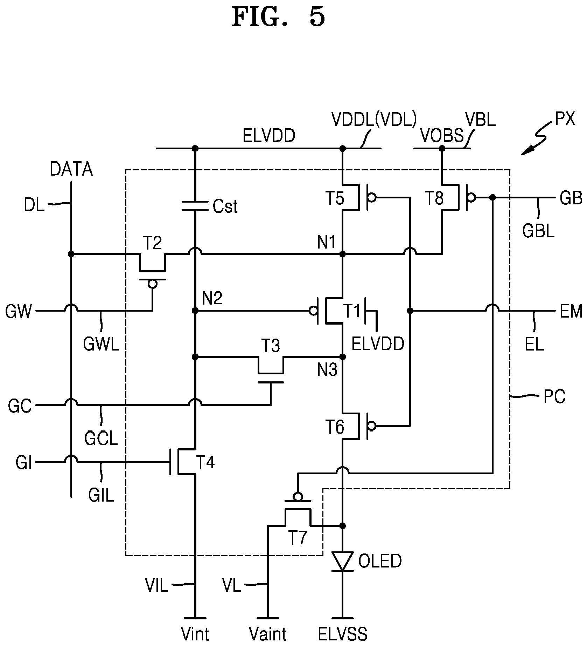

FIG. 5 is a schematic equivalent circuit diagram of a sub-pixel circuit electrically connected to a light-emitting diode of a display panel according to some embodiments.

Referring to FIG. 5, a sub-pixel PX may include a sub-pixel circuit PC. The sub-pixel circuit PC may include first to eighth transistors T1, T2, T3, T4, T5, T6, T7, and T8, and a capacitor Cst. According to some embodiments, the sub-pixel PX may be a first sub-pixel Pm, and the sub-pixel circuit PC may be a first sub-pixel circuit PCm. The sub-pixel circuit PC may be connected to a data line DL, a first gate line GWL, a second gate line GIL, a third gate line GCL, a fourth gate line GBL, and an emission control line EL. According to some embodiments, the first gate line GWL, the second gate line GIL, the third gate line GCL, the fourth gate line GBL, and the emission control line EL may each correspond to the scan line SL. In addition, the sub-pixel circuit PC may be connected to an initialization voltage line VL, a node initialization voltage line VIL, and the driving voltage line VDDL (e.g., the vertical driving voltage line VDL). The sub-pixel circuit PC may be connected to an organic light-emitting diode OLED as a light-emitting element. According to some embodiments, the organic light-emitting diode OLED may be a first light-emitting diode EDm.

It is shown in FIG. 5 that the third transistor T3 and the fourth transistor T4 of the first to eighth transistors T1, T2, T3, T4, T5, T6, T7, and T8 are N-type transistors, and the rest are P-type transistors. A first terminal of the transistor may be a source electrode or a drain electrode, and a second terminal may be an electrode different from the first terminal depending on the kind (an N type or a P type) of transistor and/or an operation condition. As an example, in the case where the first terminal is a source electrode, the second terminal may be a drain electrode.

The first transistor T1 may be connected between the driving voltage line VDDL and the organic light-emitting diode OLED. The first transistor T1 may be connected between a first node N1 and a third node N3. The first transistor T1 may be connected to the driving voltage line VDDL through the fifth transistor T5, and electrically connected to the organic light-emitting diode OLED through the sixth transistor T6. The first transistor T1 includes a gate electrode, a first terminal, and a second terminal, wherein the gate electrode is connected to a second node N2, the first terminal is connected to the first node N1, and the second terminal is connected to the third node N3. According to some embodiments, the first transistor T1 may further include a back gate electrode configured to receive a driving voltage ELVDD together with the gate electrode connected to the second node N2. The driving voltage line VDDL may be configured to transfer the driving voltage ELVDD to the first transistor T1. The first transistor T1 serves as a driving transistor and is configured to receive a data signal DATA according to a switching operation of the second transistor T2 and supply a driving current to the organic light-emitting diode OLED.

The second transistor T2 (a data-write transistor) may be connected between the data line DL and the first node N1. The second transistor T2 may be connected to the driving voltage line VDDL through the fifth transistor T5. The second transistor T2 may include a gate electrode, a first terminal, and a second terminal, wherein the gate electrode is connected to the first gate line GWL, the first terminal is connected to the data line DL, and the second terminal is connected to the first node N1. The second transistor T2 may be turned on according to a first scan signal GW transferred through the first gate line GWL and may perform a switching operation of transferring a data signal DATA to the first node N1, wherein the data signal DATA is transferred through the data line DL.

The third transistor T3 (a compensation transistor) may be connected between the second node N2 and the third node N3. The third transistor T3 may be electrically connected to the organic light-emitting diode OLED through the sixth transistor T6. The third transistor T3 may include a gate electrode, a first terminal, and a second terminal, wherein the gate electrode is connected to the third gate line GCL, the first terminal is connected to the second node N2, and the second terminal is connected to the third node N3. The third transistor T3 may be turned on according to a third scan signal GC to compensate for a threshold voltage of the first transistor T1 by diode-connecting the first transistor T1, wherein the third scan signal GC is transferred through the third scan line GCL.

The fourth transistor T4 (a node initialization transistor) may be connected between the second node N2 and the node initialization voltage line VIL. The fourth transistor T4 may include a gate electrode, a first terminal, and a second terminal, wherein the gate electrode is connected to the second gate line GIL, the first terminal is connected to the second node N2, and the second terminal is connected to the initialization voltage line VIL. The fourth transistor T4 may be turned on according to a second scan signal GI to initialize the gate electrode of the first transistor T1 by transferring an initialization voltage Vint to the gate electrode of the first transistor T1, wherein the second scan signal GI is transferred through the second gate line GIL.

The fifth transistor T5 (a first emission control transistor) may be connected between the driving voltage line VDDL and the first node N1. The sixth transistor T6 (a second emission control transistor) may be connected between the third node N3 and the organic light-emitting diode OLED. The fifth transistor T5 may include a gate electrode, a first terminal, and a second terminal, wherein the gate electrode is connected to the emission control line EL, the first terminal is connected to the driving voltage line VDDL, and the second terminal is connected to the first node N1.

The sixth transistor T6 (a second emission control transistor) may be connected between the organic light-emitting diode OLED and the third node N3. The sixth transistor T6 may include a gate electrode, a first terminal, and a second terminal, wherein the gate electrode is connected to the emission control line EL, the first terminal is connected to the third node N3, and the second terminal is connected to a sub-pixel electrode of the organic light-emitting diode OLED. The fifth transistor T5 and the sixth transistor T6 are simultaneously turned on according to an emission control signal EM, and the driving current flows through the organic light-emitting diode OLED, wherein the emission control signal EM is transferred through the emission control line EL.

The seventh transistor T7 (an initialization transistor) may be connected between the organic light-emitting diode OLED and the initialization voltage line VL. The seventh transistor T7 may include a gate electrode, a first terminal, and a second terminal, wherein the gate electrode is connected to the fourth gate line GBL, the first terminal is connected to the second terminal of the sixth transistor T6 and the pixel electrode of the organic light-emitting diode OLED, and the second terminal is connected to the initialization voltage line VIL. The seventh transistor T7 may be turned on according to a fourth scan signal GB to initialize the sub-pixel electrode of the organic light-emitting diode OLED by transferring an initialization voltage Vaint to the sub-pixel electrode of the organic light-emitting diode OLED, wherein the fourth scan signal GB is transferred through the fourth gate line GBL. The seventh transistor T7 may be simultaneously turned on with the eighth transistor T8 according to a fourth scan signal GB. According to some embodiments, the seventh transistor T7 may include two seventh transistors connected in series.

The eighth transistor T8 (a bias initialization transistor) may be connected between the first node N1 and a bias voltage line VBL. The eighth transistor T8 may include a gate electrode, a first terminal, and a second terminal, wherein the gate electrode is connected to the fourth gate line GBL, the first terminal is connected to the bias voltage line VBL, and the second terminal is connected to the first node N1. The eighth transistor T8 may be turned on according to a fourth scan signal GB and may set the first terminal of the first transistor T1 to a voltage suitable for a subsequent operation of the first transistor T1 in advance by applying a bias voltage VOBS to the first terminal of the first transistor T1.

The capacitor Cst may include a first electrode and a second electrode, wherein the first electrode is connected to the gate electrode of the first transistor T1, and the second electrode is connected to the driving voltage line VDDL. The first capacitor Cst may maintain a voltage applied to the gate electrode of the first transistor T1 by storing and maintaining a voltage corresponding to a difference between voltages of two opposite ends of the gate electrode of the first transistor T1 and the driving voltage line VDDL.

In the case where the sub-pixel PX shown in FIG. 5 is a red sub-pixel, the initialization voltage line VL may be a first initialization voltage line, and the initialization voltage Vaint may be a first initialization voltage. In the case where the sub-pixel PX shown in FIG. 5 is a blue sub-pixel or a green sub-pixel, the initialization voltage line VIL may be a second initialization voltage line, and the initialization voltage Vaint may be a second initialization voltage.

The organic light-emitting diode OLED may include the sub-pixel electrode and the opposite electrode, and the opposite electrode may be configured to receive a common voltage ELVSS. The organic light-emitting diode OLED may be configured to display images by receiving the driving current from the first transistor and emitting light.

Although it is shown in FIG. 5 that the sub-pixel circuit PC includes eight transistors and one capacitor, the embodiments according to the present disclosure are not limited thereto. The number of transistors and the number of capacitors included in the sub-pixel circuit PC, and a circuit design thereof may be variously changed.

FIGS. 6A and 6B are schematic plan views of a partial region of a display panel according to some embodiments. For example, FIG. 6A shows the component area CA, the intermediate area MA, a portion of the main display area MDA and the peripheral area PA adjacent thereto, and FIG. 6B shows the component area CA, the intermediate area MA, a portion of the main display area MDA.

FIGS. 6A and 6B show various configurations of the component area CA. The shape and size of the component area CA may be various. When viewed in a direction (e.g., a -z direction) approximately perpendicular to the display panel 10, the component area CA may have various shapes such as a circular shape, an elliptical shape, and a polygonal shape. FIG. 6A shows that the component area CA is provided in an approximately quadrangular shape, and FIG. 6B shows that the component area CA is provided in a circular shape.

Referring to FIG. 6A, according to some embodiments, at least a portion of the component area CA may be in contact with the peripheral area PA. As an example, the component area CA may be surrounded by the main display area MDA on the remaining three sides excluding the edge that is in contact with the peripheral area PA. Referring to FIG. 6B, according to some embodiments, the component area CA may be surrounded by the main display area MDA entirely.

The display area DA may further include the intermediate area MA. The intermediate area MA may be arranged between the component area CA and the main display area MDA. The intermediate area MA may be a region corresponding to a boundary between the component area CA and the main display area MDA. According to some embodiments, the intermediate area MA may be a third area.

The intermediate area MA may be arranged along the edge of the component area CA surrounded by the main display area MDA. As an example, in FIG. 6A, the intermediate area MA may be arranged along the remaining three edges excluding the edge of the quadrangular component area CA that is in contact with the peripheral area PA. In addition, in FIG. 6B, the intermediate area MA may be arranged along all of the edges of the component area CA.

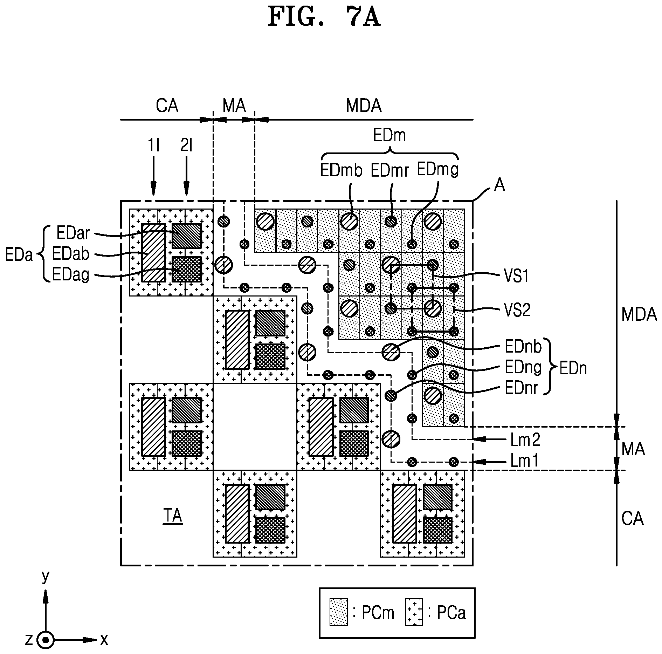

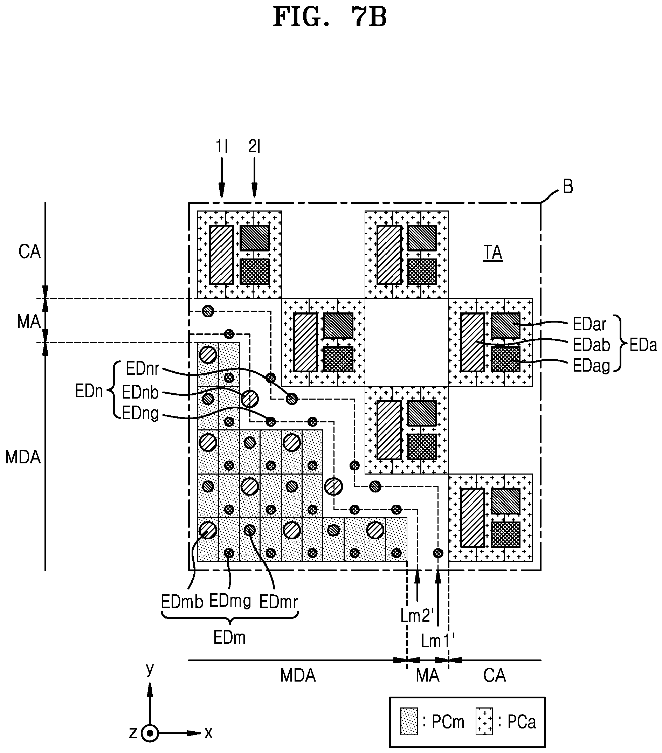

FIGS. 7A and 7B are enlarged plan views of a portion of a display panel according to some embodiments. For example, FIGS. 7A and 7B are enlarged views of a region A and a region B of FIG. 6B, respectively.

Referring to FIGS. 7A and 7B, a third sub-pixel may be arranged in the intermediate area MA. The light-emitting diodes may be arranged in the intermediate area MA. With regard to this, in the present specification, light-emitting diodes corresponding to third sub-pixels and arranged in the intermediate area MA are referred to as third light-emitting diodes EDn. The third light-emitting diode EDn may be arranged over the substrate 100.

The first light-emitting diodes EDm may include a first red light-emitting diode EDmr, a first green light-emitting diode EDmg, and a first blue light-emitting diode EDmb. The second light-emitting diodes EDa may include a second red light-emitting diode EDar, a second green light-emitting diode EDag, and a second blue light-emitting diode EDab. The third light-emitting diodes EDn may include a third red light-emitting diode EDnr, a third green light-emitting diode EDng, and a third blue light-emitting diode EDnb.

According to some embodiments, the first light-emitting diodes EDm arranged in the main display area MDA may be arranged in a pentile structure. As an example, the first red light-emitting diodes EDmr are arranged in first and third vertexes facing each other among vertexes of a virtual quadrangle VS1 with the center of the first green light-emitting diode EDmg arranged at the center of the virtual quadrangle VS1, and the first blue light-emitting diodes EDmb may be arranged at second and fourth vertexes. The first green light-emitting diodes EDmg may be arranged at four vertexes of a virtual quadrangle VS2 with the center of the first red light-emitting diode EDmr or the first blue light-emitting diode EDmb arranged at the center of the virtual quadrangle VS2.

The first red light-emitting diode EDmr, the first green light-emitting diode EDmg, and the first blue light-emitting diode EDmb may respectively have different sizes. As an example, the size of the first blue light-emitting diode EDmb may be greater than the size of the first red light-emitting diode EDmr, and the size of the first red light-emitting diode EDmr may be greater than the size of the first green light-emitting diode EDmg.

Although it is shown in FIGS. 7A and 7B that the first light-emitting diodes EDm are arranged in a pentile structure, the embodiments according to the present disclosure are not limited thereto. As an example, the first light-emitting diodes EDm may be arranged in various configurations such as a stripe structure, a mosaic configuration structure, and a delta configuration structure.

The number of second light-emitting diodes EDa arranged in the component area CA per unit area may be less than the number of first light-emitting diodes EDm arranged in the main display area MDA per unit area. As an example, the number of second light-emitting diodes EDa per unit area and the number of first light-emitting diodes EDm may be provided in ratios of 1:2, 1:4, 1:8, and 1:9. That is, the resolution of the component area CA may be 1/2, 1/4, 1/8, or 1/9 of the resolution of the main display area MDA.

The second light-emitting diodes EDa arranged in the component area CA may be arranged in various shapes. Some of the second light-emitting diodes EDa may gather to form a light-emitting diode group and be arranged in various shapes such as a stripe structure, a mosaic configuration structure, and a delta configuration structure in the light-emitting diode group.

A configuration structure of the second light-emitting diodes EDa may be different from a configuration structure of the first light-emitting diodes EDm. According to some embodiments, the second light-emitting diodes EDa may be arranged in a stripe structure. As an example, the second light-emitting diodes EDa may be arranged in an s-stripe structure in the component area CA. The second blue light-emitting diode EDab may be arranged in a first column 1I, and the second red light-emitting diode EDar and the second green light-emitting diode EDag may be alternately arranged in a second column 2I adjacent thereto. The second blue light-emitting diode EDab may be provided to correspond to one second red light-emitting diode EDar and one second green light-emitting diode EDag, and the size of the second blue light-emitting diode EDab may be greater than the size of the second red light-emitting diode EDar and the second green light-emitting diode EDag. The second blue light-emitting diode EDab may be arranged long in the y direction, and the second red light-emitting diode EDar and the second green light-emitting diode EDag may be arranged long in the x direction.

As shown in FIGS. 7A and 7B, the second light-emitting diodes EDa arranged in the component area CA may be dispersed in the component area CA. A distance between the second light-emitting diodes EDa may be greater than a distance between the first light-emitting diodes EDm in the main display area MDA. A region of the component area CA in which the second light-emitting diodes EDa (and the second sub-pixel circuits) are not arranged may be the transmission area TA.

According to some embodiments, the size (that is, an emission area) of the second light-emitting diode EDa may be different from the size (that is, an emission area) of the first light-emitting diode EDm. As an example, the size (that is, an emission area) of the second light-emitting diode EDa may be greater than the size (that is, an emission area) of the first light-emitting diode EDm.

The first light-emitting diodes EDm arranged in the main display area MDA may be electrically connected to the first sub-pixel circuits PCm in the main display area MDA. As an example, one first light-emitting diode EDm may correspond to one first sub-pixel circuit PCm. A first red light-emitting diode EDmr may be electrically connected to a corresponding first sub-pixel circuit PCm, a first green light-emitting diode EDmg may be electrically connected to a corresponding first sub-pixel circuit PCm, and a first blue light-emitting diode EDmb may be electrically connected to a corresponding first sub-pixel circuit PCm.

The second light-emitting diodes EDa arranged in the component area CA may be electrically connected to the second sub-pixel circuits PCa in the component area CA. As an example, one second light-emitting diode EDa may correspond to one second sub-pixel circuit PCa. Some of the second sub-pixel circuits PCa may gather to form one sub-pixel circuit group. As an example, a sub-pixel circuit group in the component area CA may include three second sub-pixel circuits PCa. The sub-pixel circuit groups may be arranged to be spaced apart from each other in the first direction (e.g., the x direction) and/or the second direction (e.g., the y direction) in the component area CA.

As described above, the first light-emitting diodes EDm in the main display area MDA and the second light-emitting diodes EDa in the component area CA may be different from each other in their configuration structure, size, and distance between the light-emitting diodes. Accordingly, a brightness deviation may occur in the neighborhood of the component area CA. A difference in visibility may occur for each portion in the boundary between the component area CA and the main display area MDA.

Referring to FIGS. 6A and 6B, when the configuration structure of the second light-emitting diodes EDa in the component area CA is taken account, the second red light-emitting diodes EDar and the second green light-emitting diodes EDag are arranged in the outermost portion of the component area CA in the region A of FIG 6B, while the second blue light-emitting diodes EDab and the second green light-emitting diodes EDag are arranged in the outermost portion of the component area CA in the region B that is symmetrical to the region A. Accordingly, a difference in visibility may occur in the boundary between the main display area MDA and the component area CA corresponding to the region A and the region B.

In contrast, according to some embodiments, because the third light-emitting diodes EDn are additionally arranged in the region between the component area CA and the main display area MDA, that is, the intermediate area MA corresponding to the boundary between the component area CA and the main display area MDA, a difference in visibility in the boundary between the component area CA and the main display area MDA may be reduced.

According to some embodiments, the size (that is, the emission area) of the third light-emitting diode EDn may be substantially the same as the size (that is, the emission area) of the first light-emitting diode EDm. As an example, the third red light-emitting diode EDnr may have the same size (that is, the emission area) as the first red light-emitting diode EDmr. The third green light-emitting diode EDng may have the same size (that is, the emission area) as the first green light-emitting diode EDmg. The third blue light-emitting diode EDng may have the same size (that is, the emission area) as the first blue light-emitting diode EDmb.

The third light-emitting diodes EDn in the intermediate area MA may be arranged to surround the component area CA. The intermediate area MA may include lines in which the third light-emitting diodes EDn are respectively arranged. First lines Lm1 and Lm1' and second lines Lm2 and Lm2' may be defined in the order adjacent to the component area CA. The third light-emitting diodes EDn arranged in the intermediate area MA may be arranged in one of the first lines Lm1 and Lm1' and the second lines Lm2 and Lm2'.

Because the third light-emitting diodes EDn are arranged to reduce the visibility of the boundary between the component area CA and the main display area MDA, the third light-emitting diodes EDn may be arranged different for each portion of the intermediate area MA corresponding to the boundary.

As an example, the third light-emitting diodes EDn arranged in the first line Lm1 and the second line Lm2 of the intermediate area MA in FIG. 7A may have a configuration structure different from the third light-emitting diodes EDn arranged in the first line Lm1' and the second line Lm2' of the intermediate area MA in FIG. 7B. As an example, the number of third red light-emitting diodes EDnr, third green light-emitting diodes EDng, and third blue light-emitting diodes EDnb arranged in the first line Lm1 of FIG. 7A may be different from the number of third red light-emitting diodes EDnr, third green light-emitting diodes EDng, and third blue light-emitting diodes EDnb arranged in the first line Lm1' of FIG. 7B.

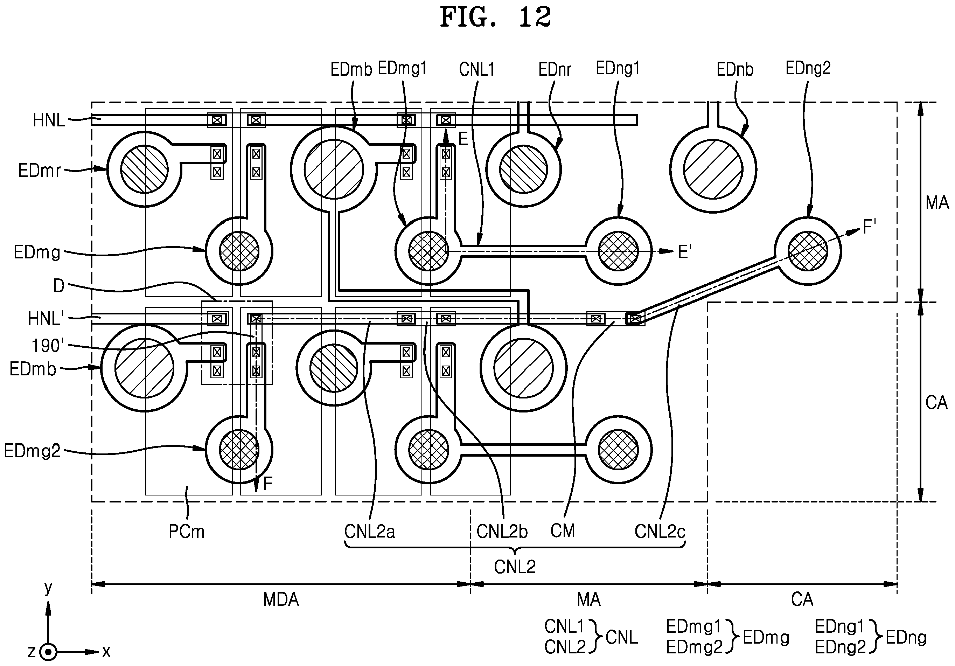

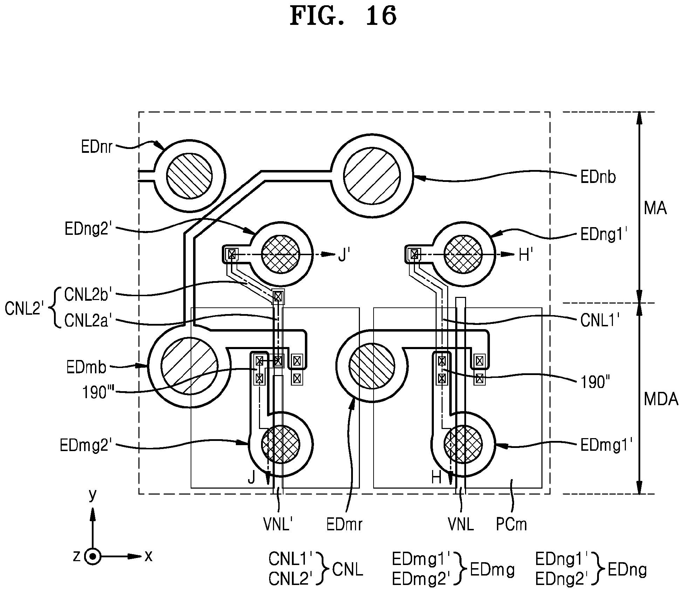

The sub-pixel circuit may not be arranged in the intermediate area MA. As described in more detail below, the third light-emitting diodes EDn arranged in the intermediate area MA may be electrically connected to the adjacent first light-emitting diodes EDm arranged in the main display area MDA. The third light-emitting diode EDn is connected to the adjacent first light-emitting diode EDm and may be driven by the first sub-pixel circuit PCm corresponding to the relevant first light-emitting diode EDm. The third light-emitting diode EDn may be electrically connected to the adjacent first light-emitting diode EDm through a connection line CNL (see FIGS. 12 and 16) described below.

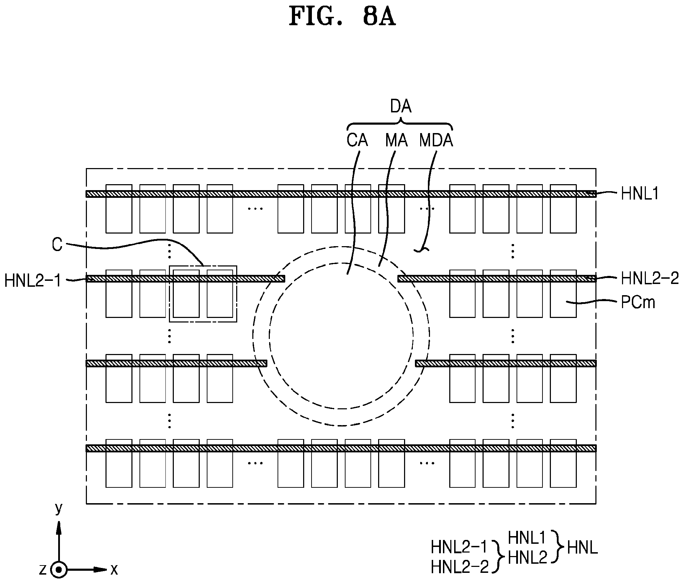

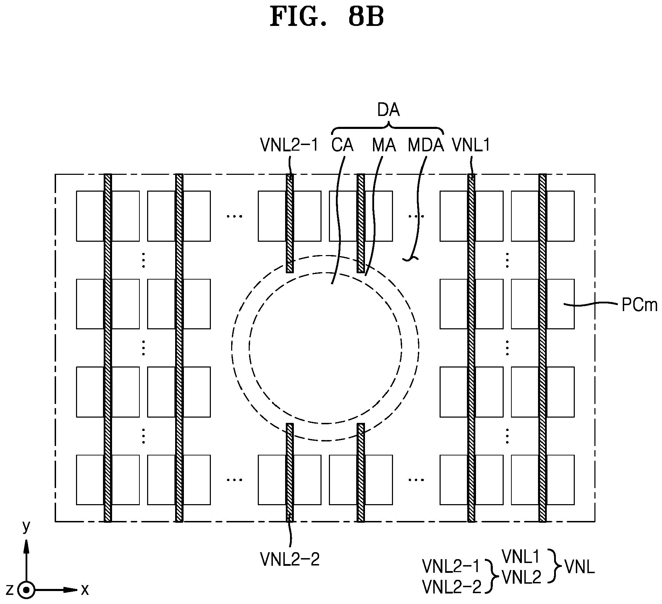

FIGS. 8A and 8B are plan views of a horizontal conductive line and a vertical conductive line passing near a component area of a display panel according to some embodiments.

Referring to FIG. 8A, the display area DA may include the component area CA including the transmission area, the main display area MDA, and the intermediate area MA.

The first sub-pixel circuits PCm may be arranged in the main display area MDA. The first sub-pixel circuits PCm arranged in the main display area MDA may be arranged in a matrix configuration in the first direction (e.g., the x direction) and the second direction (e.g., the y direction).

A horizontal conductive line HNL is located over the substrate 100 and may extend in the first direction (e.g., the x direction). The horizontal conductive line HNL may overlap the plurality of first sub-pixel circuits PCm. As an example, the horizontal conductive line HNL may overlap the first sub-pixel circuits PCm in the same column. The horizontal conductive line HNL may be provided in plurality. The horizontal conductive lines HNL may be spaced apart from each other in the second direction (e.g., the y direction) crossing the first direction (e.g., the x direction).

The horizontal conductive lines HNL may include a first horizontal conductive line HNL1 and a second horizontal conductive line HNL2. The first horizontal conductive line HNL1 may be spaced apart in the second direction (e.g., the y direction) from the component area CA. In other words, the first horizontal conductive line HNL1 may be arranged in a row not overlapping the component area CA. The second horizontal conductive line HNL2 may be arranged in a row overlapping the component area CA. The second horizontal conductive line HNL2 may not pass across the component area CA. The second horizontal conductive line HNL2 may include a first portion HNL2-1 and a second portion HNL2-2 spaced apart from each other with the component area CA therebetween. The first horizontal conductive line HNL1 and the second horizontal conductive line HNL2 may each be provided in plurality.

According to some embodiments, the horizontal conductive line HNL may be the common voltage line VSSL (see FIG. 4), for example, the horizontal common voltage line HSL (see FIG. 4).

Referring to FIG. 8B, a vertical conductive line VNL may be arranged over the substrate 100 and may extend in the second direction (e.g., the y direction). As an example, the vertical conductive line VNL may be located between the first sub-pixel circuits PCm arranged in a first column and the first sub-pixel circuits PCm arranged in a second column adjacent to the first column. The vertical conductive line VNL may be arranged in plurality. The vertical conductive lines VNL may be spaced apart from each other in the first direction (e.g., the x direction) crossing the second direction (e.g., the y direction).

The vertical conductive lines VNL may include a first vertical conductive line VNL1 and a second vertical conductive line VNL2. The first vertical conductive line VNL1 may be spaced apart in the first direction (e.g., the x direction) from the component area CA. In other words, the first vertical conductive line VNL1 may be arranged in a column not overlapping the component area CA. The second vertical conductive line VNL2 may be arranged in a column overlapping the component area CA. The second vertical conductive line VNL2 may not pass across the component area CA. The second vertical conductive line VNL2 may include a first portion VNL2-1 and a second portion VNL2-2 spaced apart from each other with the component area CA therebetween. The first vertical conductive line VNL1 and the second vertical conductive line VNL2 may each be provided in plurality.

According to some embodiments, the vertical conductive line VNL may be the common voltage line VSSL (see FIG. 4), for example, the vertical common voltage line VSL (see FIG. 4). According to some embodiments, the vertical conductive line VNL may be a voltage transfer line configured to transfer a voltage required to drive the first sub-pixel circuit PCm.

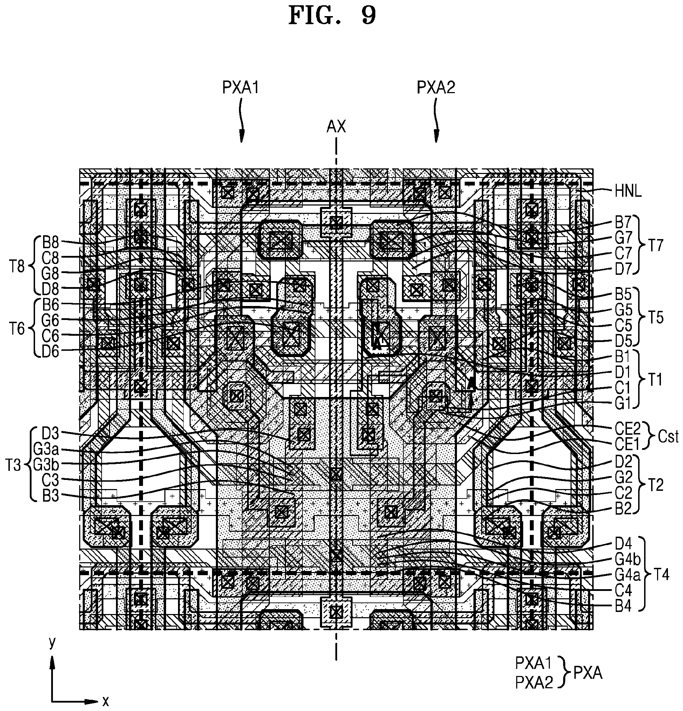

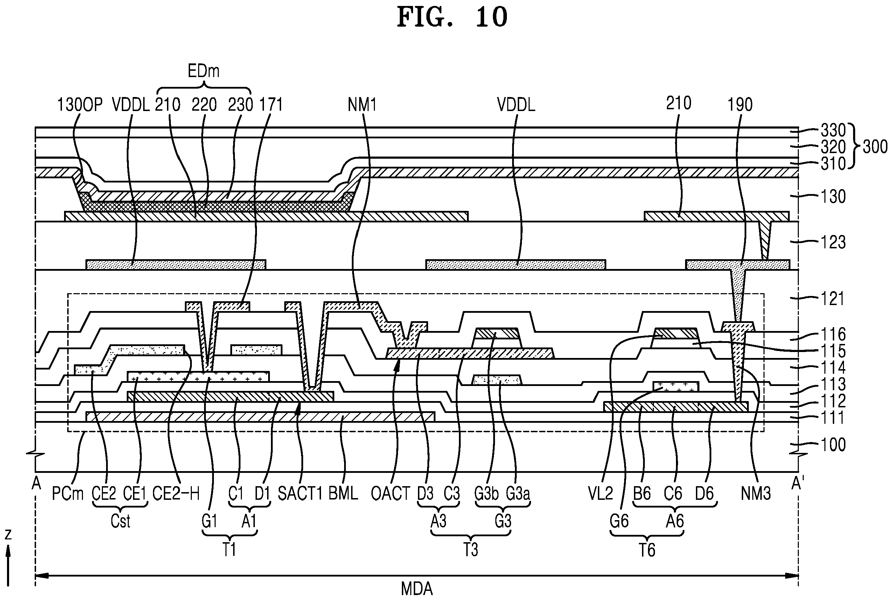

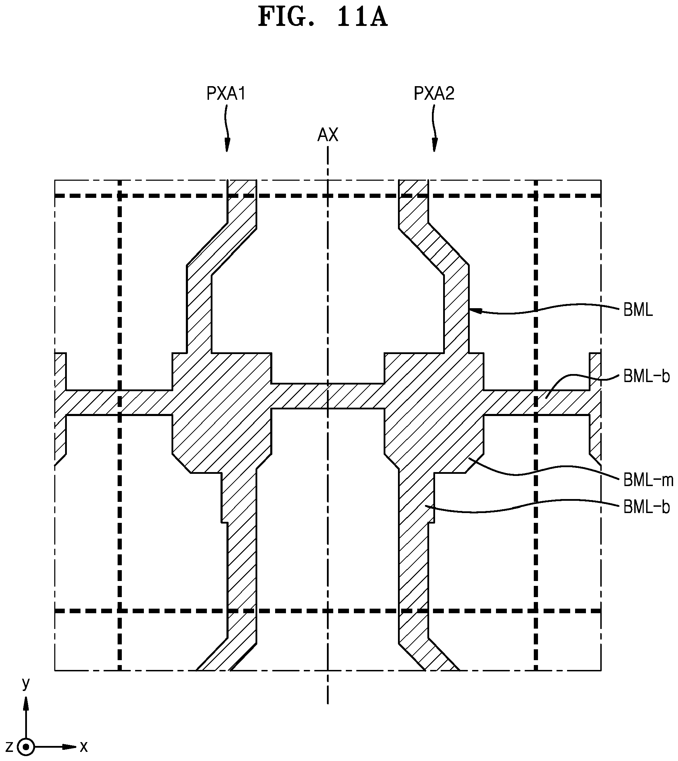

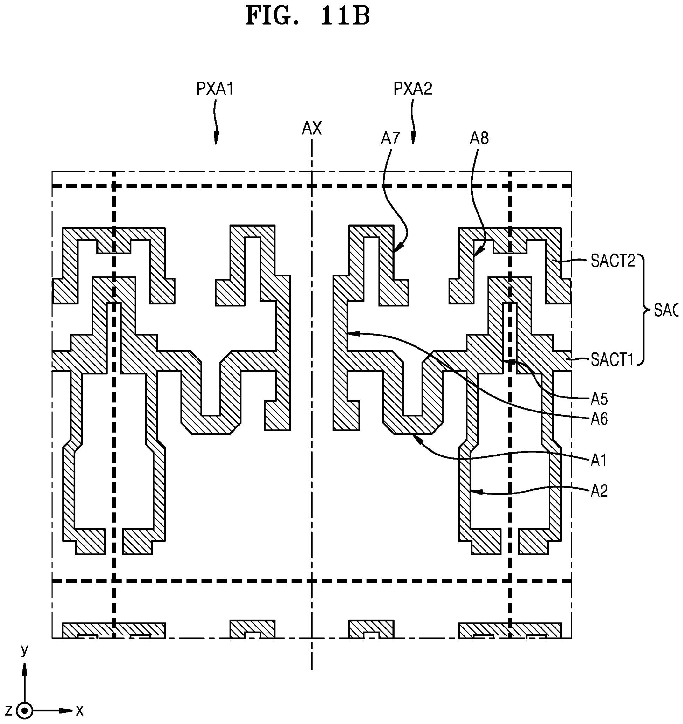

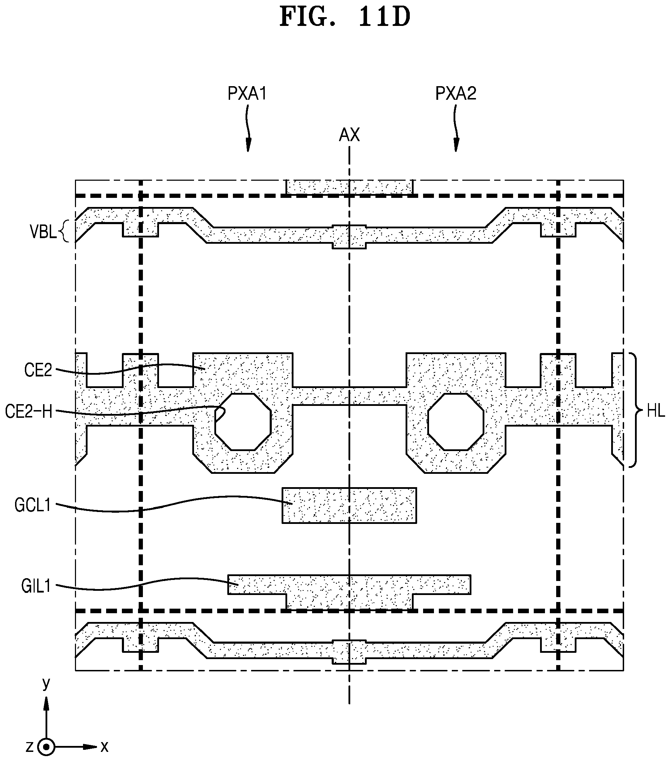

FIG. 9 is a schematic plan view of positions of elements arranged in a region of a sub-pixel circuit according to some embodiments, and FIG. 10 is a cross-sectional view of the sub-pixel circuit, taken along the line A-A' of FIG. 9. FIGS. 11A to 11I are schematic arrangement views of elements of FIG. 9, for each layer. FIG. 9 is an enlarged view of a region C of FIG. 8A.

The main display area MDA may include a plurality of sub-pixel circuit areas PXA. The sub-pixel circuit area PXA may be a region in which a sub-pixel circuit, for example, the first sub-pixel circuit PCm is arranged. The sub-pixel circuit areas PXA may be arranged in the first direction (e.g., the x direction) and the second direction (e.g., the y direction).

In the sub-pixel area PXA, a first sub-pixel circuit area PXA1 and a second sub-pixel circuit area PXA2 are repeated in the x direction, wherein the first sub-pixel circuit PCm corresponding to the first red light-emitting diode EDmr or the first blue light-emitting diode EDmb is arranged in the first sub-pixel circuit area PXA1, and the first sub-pixel circuit PCm corresponding to the first green light-emitting diode EDmg is arranged in the second sub-pixel circuit area PXA2.

A sub-pixel circuit arranged in the first sub-pixel circuit area PXA1 and a sub-pixel circuit arranged in the second sub-pixel circuit area PXA2 may be line symmetrical to each other with respect to a boundary line AX.

Hereinafter, the case where the first sub-pixel circuit PCm corresponding to the first red light-emitting diode EDmr is arranged in the first sub-pixel circuit area PXA1, and the first sub-pixel circuit PCm corresponding to the first green light-emitting diode EDmg is arranged in the second sub-pixel circuit area PXA2 is described as an example. Each of the first sub-pixel circuits PCm includes first to eighth transistors T1, T2, T3, T4, T5, T6, T7, and T8.

As shown in FIGS. 9, 10, and 11A, a bottom metal layer BML may be located on the substrate 100 (see FIG. 10). As an example, the bottom metal layer BML may include metal such as molybdenum, titanium, and aluminium. The bottom metal layer BML may be, for example, a single layer of molybdenum, a double layer of molybdenum and titanium, or a triple layer of a titanium layer, an aluminum layer, and a titanium layer.

As shown in FIG.11A, the bottom metal layer BML may include a portion (referred to as a main portion BML-m, hereinafter) located in each of the first and second sub-pixel circuit areas PXA1 and PXA2. Each main portion BML-m may be connected to other portions (referred to as branch portions BML-b, hereinafter) extending in the x direction and the y direction. The main portion BML-m arranged in the first sub-pixel circuit area PXA1 may be directly connected to the main portion BML-m arranged in the second sub-pixel circuit area PXA2.

Referring to FIGS. 9, 10, and 11B, a buffer layer 111 may be located on the bottom metal layer BML, and a first semiconductor layer SACT may be located on the buffer layer 111. The first semiconductor layer SACT may include a silicon semiconductor. The first semiconductor layer SACT may include a first sub-semiconductor layer SACT1 and a second sub-semiconductor layer SACT2 separated from the first sub-semiconductor layer SACT1. As described below, the second sub-semiconductor layer SACT2 may be electrically connected to the first sub-semiconductor layer SACT1.

The first sub-semiconductor layer SACT1 may have various curved shapes. The first sub-semiconductor layer SACT1 may include a first semiconductor layer A1, a second semiconductor layer A2, a fifth semiconductor layer A5, a sixth semiconductor layer A6, and a seventh semiconductor layer A7 of the first transistor T1, the second transistor T2, the fifth transistor T5, the sixth transistor T6, and the seventh transistor T7. The second sub-semiconductor layer SACT2 may include an eighth semiconductor layer A8 of the eighth transistor T8. Each semiconductor layer may include a channel region, a source region, and a drain region, wherein the source region and the drain region are on two opposite sides of the channel region.

Referring to FIG. 9, the first sub-semiconductor layer SACT1 may include a channel region C1, a source region B1, and a drain region D1 of the first transistor T1, a channel region C2, a source region B2, and a drain region D2 of the second transistor T2, a channel region C5, a source region B5, and a drain region D5 of the fifth transistor T5, a channel region C6, a source region B6, and a drain region D6 of the sixth transistor T6, and a channel region C7, a source region B7, and a drain region D7 of the seventh transistor T7. The second sub-semiconductor layer SACT2 may include a channel region C8, a source region B8, and a drain region D8 of the eighth transistor T8. Because the channel region C1 of the first transistor T1 may be formed to be long by being curved, the driving range of a gate voltage applied to the gate electrode may be expanded. The channel region C1 of the first transistor T1 may have various shapes such as ' ⊏', '2', 'S', 'M', and 'W'.

Referring to FIGS. 9, 10, and 11C, a first gate insulating layer 112 may be located on the buffer layer 111 to cover the first semiconductor layer SACT, a gate electrode G1 of the first transistor T1 may be arranged in an island shape on the first gate insulating layer 112, and the node initialization voltage line VIL, the first gate line GWL, the emission control line EL, and the fourth gate line GBL may extend in the x direction.

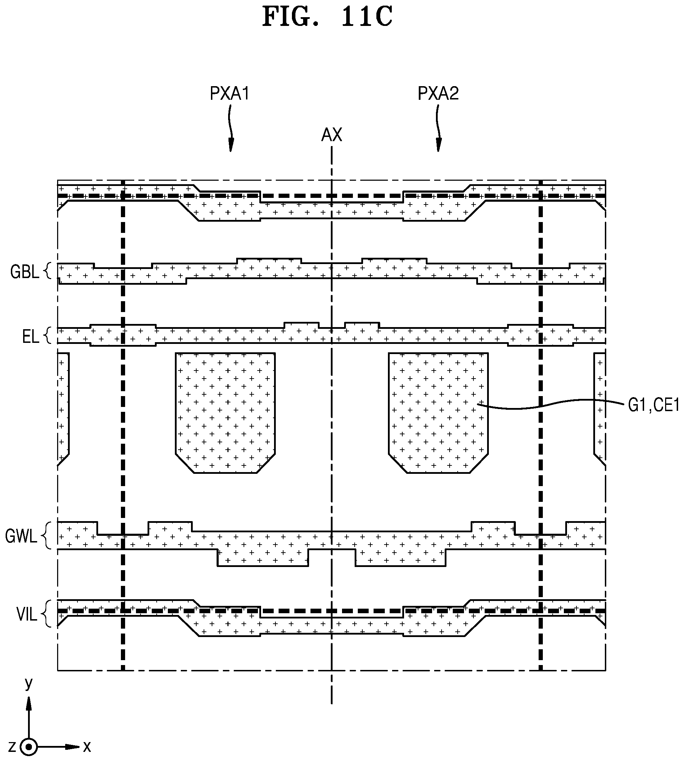

Referring to FIGS. 9 and 11C, the gate electrode G1 of the first transistor T1 may serve as a lower electrode CE1, which is a first electrode of the capacitor Cst. A gate electrode G2 of the second transistor T2 may be a portion of the first gate line GWL crossing (overlapping) the first sub-semiconductor layer SACT1. A gate electrode G5 of the fifth transistor T5 and a gate electrode G6 of the sixth transistor T6 may be portions of the emission control line EL crossing the first sub-semiconductor layer SACT1. A gate electrode G7 of the seventh transistor T7 may be a portion of the fourth gate line GBL crossing (overlapping) the first sub-semiconductor layer SACT1. A gate electrode G8 of the eighth transistor T8 may be a portion of the fourth gate line GBL crossing (overlapping) the second sub-semiconductor layer SACT2.

As shown in FIGS. 9, 10, and 11D, a first interlayer insulating layer 113 may be located on the first gate insulating layer 112. The bias voltage line VBL, an electrode voltage line HL, a lower gate line GIL1 of the second gate line GIL, and a lower gate line GCL1 of the third gate line GCL may each extend in the x direction on the first interlayer insulating layer 113.

A portion of the electrode voltage line HL is an upper electrode CE2, which is a second electrode of the capacitor Cst, and may cover the lower electrode CE1 of the capacitor Cst. The upper electrodes CE2 of the capacitors Cst respectively arranged in the first and second sub-pixel circuit areas PXA1 and PXA2 may be connected to each other through the electrode voltage line HL. An opening CE2-H may be formed in the upper electrode CE2 of the capacitor Cst.

Referring to FIGS. 9, 10, and 11E, a second interlayer insulating layer 114 may be located on the first interlayer insulating layer 113, and a second semiconductor layer OACT may be located on the second interlayer insulating layer 114. The second semiconductor layer OACT may include an oxide semiconductor. The second semiconductor layer OACT may include a third semiconductor layer A3 and a fourth semiconductor layer A4 of the third transistor T3 and the fourth transistor T4. Each of the third semiconductor layer A3 and the fourth semiconductor layer A4 may include a channel region, a source region, and a drain region.

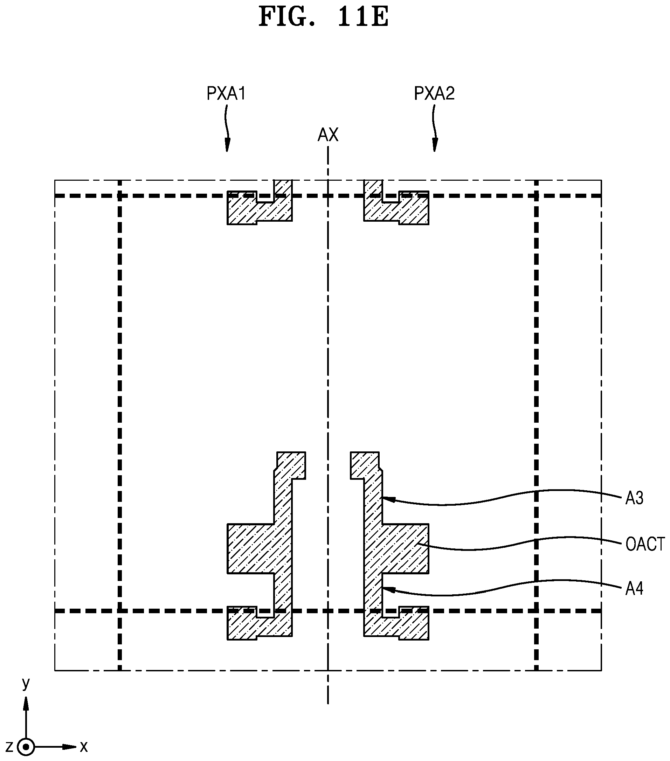

Referring to FIGS. 9 and 11E, the second semiconductor layer OACT may include a channel region C3, a source region B3, and a drain region D3 of the third transistor T3, and a channel region C4, a source region B4, and a drain region D4 of the fourth transistor T4.

A source region and a drain region of the semiconductor layer of each of the first to eighth transistors T1, T2, T3, T4, T5, T6, T7, and T8 may respectively correspond to the first terminal (or the second terminal) and the second terminal (or the first terminal) described with reference to FIG. 5. The source region or the drain region may be interpreted as a source electrode or a drain electrode of the transistor depending on the case.

Referring to FIGS. 9, 10, and 11F, a second gate insulating layer 115 may be located on the second interlayer insulating layer 114. An upper gate line GIL2 of the second gate line GIL, an upper gate line GCL2 of the third gate line GCL, a first initialization voltage line VL1, and a second initialization voltage line VL2 may each extend in the x direction on the second gate insulating layer 115. According to some embodiments, the second gate insulating layer 115 may be located only under the upper gate line GIL2 of the second gate line GIL, the upper gate line GCL2 of the third gate line GCL, the first initialization voltage line VL1, and the second initialization voltage line VL2. According to some embodiments, the second gate insulating layer 115 may be arranged over the substrate 100 entirely.

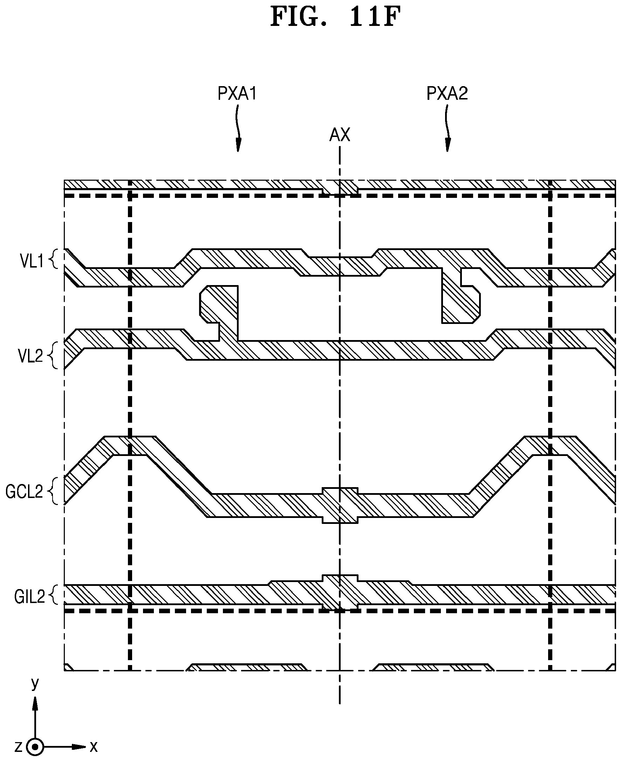

Referring to FIGS. 9 and 11F, a gate electrode of the third transistor T3 may be a portion of the third gate line GCL crossing (overlapping) the second semiconductor layer OACT. The gate electrode of the third transistor T3 may include a lower gate electrode G3a and an upper gate electrode G3b, wherein the lower gate electrode G3a is a portion of the lower gate line GCL1 of the third gate line GCL, and the upper gate electrode G3b is a portion of the upper gate line GCL2. The gate electrode of the fourth transistor T4 may include a lower gate electrode G4a and an upper gate electrode G4b, wherein the lower gate electrode G4a is a portion of the lower gate line GIL1 of the second gate line GIL, and the upper gate electrode G4b is a portion of the upper gate line GIL2. That is, the third transistor T3 and the fourth transistor T4 may each have a double gate structure including gate electrodes respectively over and below the second semiconductor layer OACT.

The first initialization voltage line VL1 may overlap the fourth gate line GBL. The second initialization voltage line VL2 may overlap the emission control line EL.

The first initialization voltage line VL1 may be electrically connected to a drain region of the seventh transistor T7 in the second sub-pixel circuit area PXA2 in which the first green light-emitting diode EDmg is arranged. The second initialization voltage line VL2 may be electrically connected to a drain region of the seventh transistor T7 in the first sub-pixel circuit area PXA1 in which the first red light-emitting diode EDmr is arranged.

As shown in FIGS. 9, 10, and 11G, a third interlayer insulating layer 116 may be located on the second interlayer insulating layer 114. First to sixth connection electrodes NM1, NM2, NM3, NM4, NM5, and NM6, an auxiliary driving voltage line VDDLa, a voltage transfer line BL, and a first sub-portion HNLa of the horizontal conductive line HNL may be located on the third interlayer insulating layer 116.

The voltage transfer line BL may extend in the y direction, and the first sub-portion HNLa of the horizontal conductive line HNL may extend in the x direction. The voltage transfer line BL may be arranged to overlap the boundary line AX between the first sub-pixel circuit area PXA1 and the second sub-pixel circuit area PXA2. The voltage transfer line BL may be electrically connected to the bias voltage line VBL through a contact hole.

Referring to FIG. 10, one end of a node connection electrode 171 may be electrically connected to the second semiconductor layer OACT by being in contact with the second semiconductor layer OACT through a contact hole. One end of the node connection electrode 171 may be electrically connected to the source region B3 of the third transistor T3 and the drain region D4 of the fourth transistor T4 through the contact hole passing through the second interlayer insulating layer 114. Another end of the node connection electrode 171 may be electrically connected to the gate electrode G1 of the first transistor T1 through a contact hole passing through the first gate insulating layer 112, the first interlayer insulating layer 113, and the second interlayer insulating layer 114. In the opening CE2-H of the upper electrode CE2 of the capacitor Cst, the contact hole is spaced apart from the edge of the opening CE2-H. Accordingly, the node connection electrode 171 may be electrically insulated from the upper electrode CE2.

The first connection electrode NM1 may be electrically connected to the drain region D1 of the first transistor T1 through contact hole. The first connection electrode NM1 may be electrically connected to the drain region D3 of the third transistor T3 through a contact hole.

The second connection electrode NM2 may be electrically connected to the source region B2 of the second transistor T2 through a contact hole.

The third connection electrode NM3 may be electrically connected to the drain region D6 of the sixth transistor T6 through a contact hole passing through, for example, the insulating layers 112, 113, 114, and 116.

The fourth connection electrode NM4 may be electrically connected to the source region B1 of the first transistor T1 and the drain region D5 of the fifth transistor T5 through contact holes. The fourth connection electrode NM4 may be electrically connected to the drain region D8 of the eighth transistor T8 through a contact hole.

The auxiliary driving voltage line VDDLa may be electrically connected to the source region B5 of the fifth transistor T5 through a contact hole. The auxiliary driving voltage line VDDLa may be electrically connected to the electrode voltage line HL through a contact hole.

The fifth connection electrode NM5 may be electrically connected to the first initialization voltage line VIL1 through a contact hole in the second sub-pixel circuit area PXA2 in which the sub-pixel circuit of the first green light-emitting diode EDmg is arranged. The fifth connection electrode NM5 may be electrically connected to the second initialization voltage line VIL2 through a contact hole in the first sub-pixel circuit area PXA1 of the sub-pixel circuit areas PXA1 in which the sub-pixel circuit of the first red light-emitting diode EDmr is arranged. The fifth connection electrode NM5 may be electrically connected to the drain region D7 of the seventh transistor T7 through a contact hole.

The sixth connection electrode NM6 may be electrically connected to the source region B8 of the eighth transistor T8 through a contact hole. The sixth connection electrode NM6 may be electrically connected to the bias voltage line VBL through a contact hole.

A seventh connection electrode NM7 may be electrically connected to the node initialization voltage line VIL through a contact hole. The seventh connection electrode NM7 may be electrically connected to the source region B4 of the fourth transistor T4 through a contact hole.

The first to seventh connection electrodes NM1, NM2, NM3, NM4, NM5, NM6, and NM7, the auxiliary driving voltage line VDDLa, the voltage transfer line BL, and the first sub-portion HNLa of the horizontal conductive line HNL may include aluminium (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu), and include a single layer or a multi-layer including the above materials. As an example, the first to seventh connection electrodes NM1, NM2, NM3, NM4, NM5, NM6, and NM7, the auxiliary driving voltage line VDDLa, the voltage transfer line BL, and the first sub-portion HNLa of the horizontal conductive line HNL may include a triple layered structure in which a titanium layer, an aluminium layer, and a titanium layer are stacked.

As shown in FIGS. 9, 10, and 11H, a first organic insulating layer 121 may be located on the third interlayer insulating layer 116, and a connection electrode 190 may be located on the first organic insulating layer 121. A second sub-portion HNLb may be located on the horizontal conductive line HNL. In addition, the data line DL and the driving voltage line VDDL may extend in the y direction on the first organic insulating layer 121.

The data line DL may be electrically connected to the second connection electrode NM2 through a contact hole passing through the first organic insulating layer 121, and thus, be electrically connected to the source region B2 of the second transistor T2.

The driving voltage line VDDL may be electrically connected to the auxiliary driving voltage line VDDLa through a contact hole passing through the first organic insulating layer 121. Accordingly, because the auxiliary driving voltage line VDDLa extending in the y direction is connected to the electrode voltage line HL extending in the x direction, the driving voltage line VDDL may have a mesh structure.

The connection electrode 190 may be electrically connected to the third connection electrode NM3 through a contact hole passing through the first organic insulating layer 121 and thus be electrically connected to the drain region D6 of the sixth transistor T6.

The second sub-portion HNLb of the horizontal conductive line HNL may extend in the x direction and be arranged over the first sub-pixel circuit area PXA1 and the second sub-pixel circuit area PXA2. The second sub-portion HNLb of the horizontal conductive line HNL may electrically connect adjacent first sub-portions HNLa. As an example, the second sub-portion HNLb of the horizontal conductive line HNL may be electrically connected to the first sub-portion HNLa passing across the first sub-pixel circuit area PXA1 through a contact hole, and be electrically connected to the first sub-portion HNLa passing across the second sub-pixel circuit area PXA2 through a contact hole.

The data line DL, the driving voltage line VDDL, the connection electrode 190, and the second sub-portion HNLb of the horizontal conductive line HNL may include aluminium (Al), platinum (Pt), palladium (Pd), silver (Ag), magnesium (Mg), gold (Au), nickel (Ni), neodymium (Nd), iridium (it may include Ir), chromium (Cr), lithium (Li), calcium (Ca), molybdenum (Mo), titanium (Ti), tungsten (W), and/or copper (Cu), and include a single layer or a multi-layer including the above materials. As an example, the data line DL, the driving voltage line VDDL, the connection electrode 190, and the second sub-portion HNLb of the horizontal conductive line HNL may include a structure in which a titanium layer, an aluminium layer, and a titanium layer are stacked.

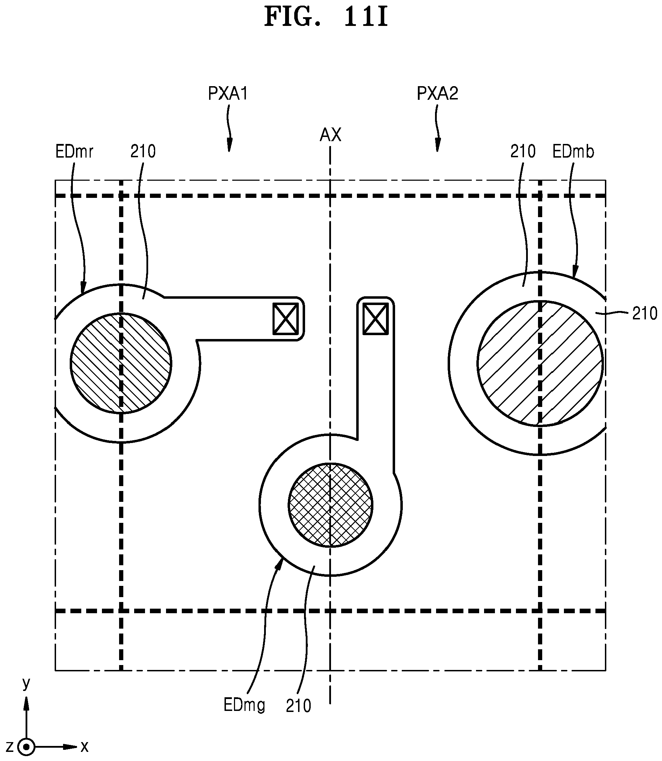

Referring to FIGS. 9, 10, and 11I, a second organic insulating layer 123 may be located on the first organic insulating layer 121, and a sub-pixel electrode 210 of the first light-emitting diode EDm may be located on the second organic insulating layer 123. The first light-emitting diode EDm may include the sub-pixel electrode 210, an emission layer 220, and an opposite electrode 230. FIG. 11I shows the sub-pixel electrode 210 of each of the first red light-emitting diode EDmr, the first green light-emitting diode EDmg, and the first blue light-emitting diode EDmb.

A bank layer 130 may be located on the sub-pixel electrode 210. The bank layer 130 may include an opening 130OP corresponding to an emission area of the sub-pixel and define the emission area of the sub-pixel.

The sub-pixel electrode 210 may include a light-transmissive conductive oxide such as indium tin oxide (ITO), indium zinc oxide (IZO), zinc oxide (ZnO), indium oxide (In₂O₃), indium gallium oxide (IGO), or aluminium zinc oxide (AZO). The sub-pixel electrode 210 may include a reflective layer including silver (Ag), magnesium (Mg), aluminium (Al), platinum (Pt), palladium (Pd), gold (Au), nickel (Ni), neodymium (Nd), iridium (Ir), chromium (Cr), or a compound thereof. As an example, the sub-pixel electrode 210 may have a three-layered structure of ITO/Ag/ITO.

The emission layer 220 may be located in the opening 130OP of the bank layer 130, and the opposite electrode 230 may be located on the bank layer 130. The sub-pixel electrode 210, the emission layer 220, and the opposite electrode 230 may configure an organic light-emitting diode.

The emission layer 220 may include a polymer organic material or a lowmolecular weight organic material emitting light having a preset color. Besides various kinds of organic materials, the emission layer 220 may further include a metalcontaining compound such as an organic metal compound, and an inorganic material such as quantum dots. According to some embodiments, at least one functional layer may be further located on and/or under the emission layer 220. As an example, a first functional layer and a second functional layer may be further located under and on the emission layer 220. The first functional layer may include, for example, a hole transport layer (HTL), or include an HTL and a hole injection layer (HIL). The second functional layer is an element located on the emission layer 220 and may be optional. The second functional layer may include an electron transport layer (ETL) and/or an electron injection layer (EIL).

The opposite electrode 230 may be located on the emission layer 220. The opposite electrode 230 may be formed as one body over the plurality of organic light-emitting diodes to correspond to the plurality of sub-pixel electrodes 210. The opposite electrode 230 may include a metal having a small work function, an alloy, a conductive compound, or an arbitrary combination thereof. As an example, the opposite electrode 230 may include lithium (Li), silver (Ag), magnesium (Mg), aluminium (Al), aluminiumlithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The opposite electrode 230 may be a transmissive electrode, a semi-transmissive electrode, or a reflective electrode.

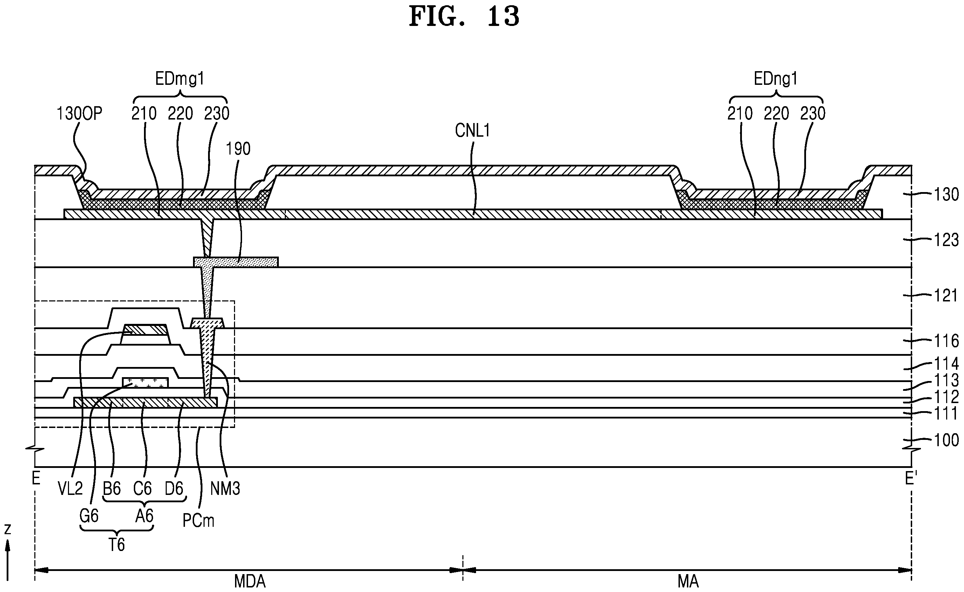

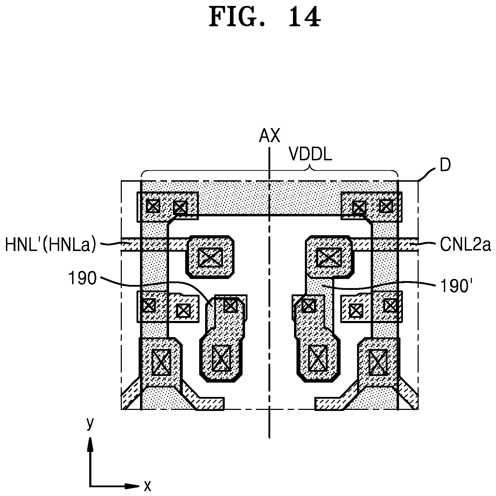

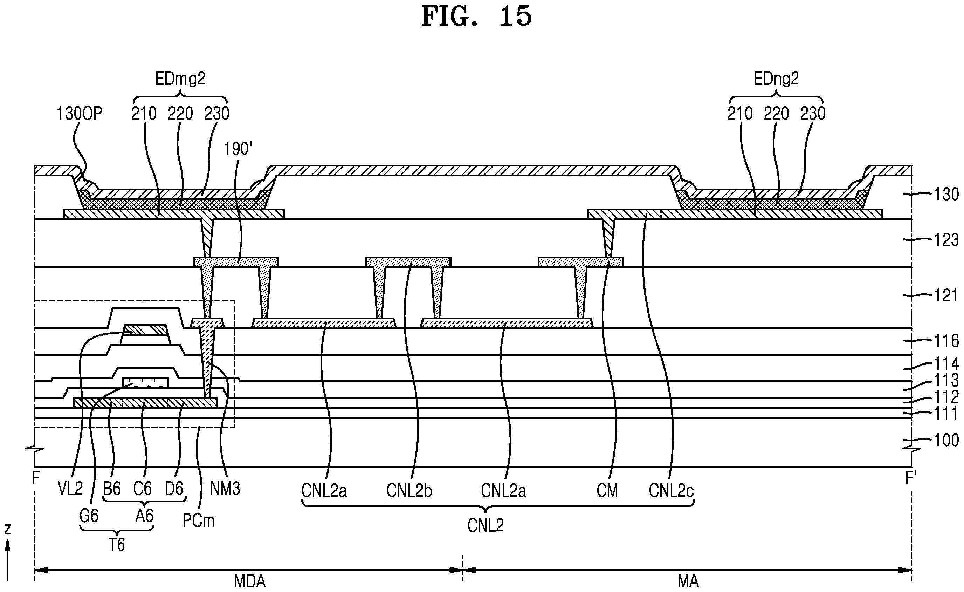

FIG. 12 is a schematic plan view of a portion of a main display area and an intermediate area of a display panel according to some embodiments. FIG. 13 is a cross-sectional view of the main display area and the intermediate area, taken along the line E-E' of FIG. 12. FIG. 14 is an enlarged plan view of some layers of a region D of FIG. 12. FIG. 15 is a cross-sectional view of the main display area and the intermediate area, taken along the line F-F' of FIG. 12. A configuration form of the third light-emitting diodes EDn in the intermediate area MA shown in FIG. 12 is provided as an example, and the embodiments according to the present disclosure are not limited thereto.

As described above with reference to FIGS. 7A and 7B, the third light-emitting diodes EDn arranged in the intermediate area MA may be electrically connected to the adjacent first light-emitting diodes EDm arranged in the main display area MDA. The third light-emitting diodes EDn may be electrically connected to the adjacent first light-emitting diodes EDm through connection lines CNL.

The third light-emitting diodes EDn may include third red light-emitting diodes EDnr, third green light-emitting diodes EDng, and third blue light-emitting diodes EDnb. The first light-emitting diodes EDm may include first red light-emitting diodes EDmr, first green light-emitting diodes EDmg, and first blue light-emitting diodes EDmb.

The third red light-emitting diode EDnr may be electrically connected to the adjacent first red light-emitting diode EDmr through a connection line CNL. The third green light-emitting diode EDng may be electrically connected to the adjacent first green light-emitting diode EDmg through a connection line CNL. The third blue light-emitting diode EDnb may be electrically connected to the adjacent first blue light-emitting diode EDmb through a connection line CNL.

Hereinafter, the case of electrically connecting the third green light-emitting diode EDng to the adjacent first green light-emitting diode EDmg through the connection line CNL is described as an example. The same or similar connection line CNL is also applicable to the connection of the third blue light-emitting diode EDnb to the adjacent first blue light-emitting diode EDmb, and the connection of the third red light-emitting diode EDnr to the adjacent first red light-emitting diode EDmr.

According to some embodiments, the third green light-emitting diodes EDng arranged in the intermediate area MA may include a 3-1 green light-emitting diode EDng1 and a 3-2 green light-emitting diode EDng2. The first green light-emitting diodes EDmg arranged in the main display area MDA may include a 1-1 green light-emitting diode EDmg1 and a 1-2 green light-emitting diode EDmg2. According to some embodiments, the connection lines CNL may include a first connection line CNL1 and a second connection line CNL2.

According to some embodiments, the 3-1 green light-emitting diode EDng1 may be electrically connected to the adjacent 1-1 green light-emitting diode EDmg1 through the first connection line CNL1. In other words, the sub-pixel electrode 210 of the 3-1 green light-emitting diode EDng1 may be electrically connected to the sub-pixel electrode 210 of the adjacent 1-1 green light-emitting diode EDmg1 through the first connection line CNL1. The first connection line CNL1 may extend in the x direction.

Referring to FIG. 13, the first sub-pixel circuit PCm located on the substrate 100 may be electrically connected to the sub-pixel electrode 210 of the 1-1 green light-emitting diode EDmg1 through the connection electrode 190 on the first organic insulating layer 121. The 1-1 green light-emitting diode EDmg1 may include the sub-pixel electrode 210, the emission layer 220, and the opposite electrode 230. The 1-1 green light-emitting diode EDmg1 may be driven by the first sub-pixel circuit PCm located therebelow.

The sub-pixel electrode 210 of the 3-1 green light-emitting diode EDng1 may be electrically connected to the 1-1 green light-emitting diode EDmg1 through the first connection line CNL1 on the second organic insulating layer 123. The first connection line CNL1 may be arranged on the same layer as the sub-pixel electrode 210 of the 1-1 green light-emitting diode EDmg1 and the sub-pixel electrode 210 of the 3-1 green light-emitting diode EDng1 and may include the same material as the sub-pixel electrode 210 of the 1-1 green light-emitting diode EDmg1 and the sub-pixel electrode 210 of the 3-1 green light-emitting diode EDng1. The first connection line CNL1 may be integrally formed with the sub-pixel electrode 210 of the 1-1 green light-emitting diode EDmg1 and the sub-pixel electrode 210 of the 3-1 green light-emitting diode EDng1.

Referring to FIGS. 12 and 14, the 3-2 green light-emitting diode EDng2 may be electrically connected to the adjacent 1-2 green light-emitting diode EDmg2 through the second connection line CNL2. In other words, the sub-pixel electrode 210 of the 3-2 green light-emitting diode EDng2 may be electrically connected to the sub-pixel electrode 210 of the adjacent 1-2 green light-emitting diode EDmg2 through the second connection line CNL2.

According to some embodiments, a distance between the 3-2 green light-emitting diode EDng2 and the 1-2 green light-emitting diode EDmg2 may be greater than a distance between the 3-1 green light-emitting diode EDng1 and the 1-1 green light-emitting diode EDmg1. The second connection line CNL2 may be formed longer than the first connection line CNL1. According to some embodiments, the second connection line CNL2 may include a first portion CNL2a, a second portion CNL2b, a connection electrode CM, and a third portion CNL2c.

Horizontal conductive lines HNL and HNL' may be arranged in the main display area MDA to pass across the first sub-pixel circuits PCm. In this case, the horizontal conductive lines HNL and HNL' may correspond to the second horizontal conductive line HNL2, for example, the first portion HNL2-1 of the second horizontal conductive line HNL2 described with reference to FIG. 8A. The horizontal conductive lines HNL and HNL' may overlap the first sub-pixel circuits PCm arranged in the same row and may not pass across the component area CA. According to some embodiments, an end of the horizontal conductive line HNL may extend to the intermediate area MA. An end of the horizontal conductive line HNL' may be located in the main display area MDA adjacent to the intermediate area MA.

According to some embodiments, the second connection line CNL2 may be arranged on the same row as the horizontal conductive line HNL'. The second connection line CNL2 may be arranged between the horizontal conductive line HNL' and the component area CA.

Referring to FIGS. 12 and 15, an end of the horizontal conductive line HNL' may be arranged adjacent to the first portion CNL2a of the second connection line CNL2. The first sub-portion HNLa of the horizontal conductive line HNL' corresponding to an end of the horizontal conductive line HNL' may be spaced apart from the first portion CNL2a of the second connection line CNL2 and may not be electrically connected to the first portion CNL2a of the second connection line CNL2. The first portion CNL2a of the second connection line CNL2 may be electrically connected to the 1-2 green light-emitting diode EDmg2 through a connection electrode 190'.

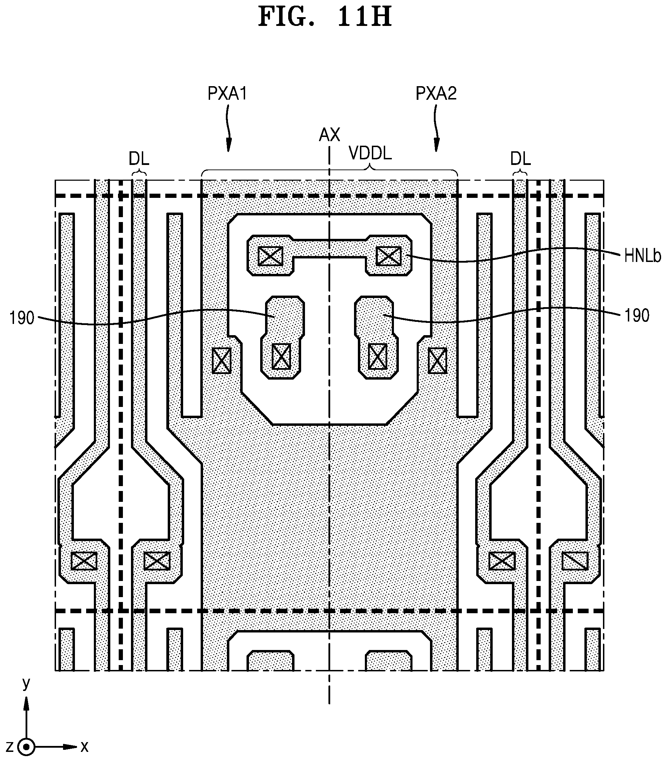

In the sub-pixel circuit area in which the first sub-pixel circuit PCm corresponding to the 1-2 green light-emitting diode EDmg2 is arranged, the connection electrode 190' may extend to overlap the first portion CNL2a of the second connection line CNL2. In addition, a portion of the horizontal conductive line HNL of FIGS. 9 and 11H that connect the first portion CNL2a of the second connection line CNL2 with the first sub-portion HNLa of the horizontal conductive line HNL' may be omitted.

Referring to FIG. 14, the first sub-pixel circuit PCm located on the substrate 100 may be electrically connected to the sub-pixel electrode 210 of the 1-2 green light-emitting diode EDmg2 through the connection electrode 190' on the first organic insulating layer 121. The 1-2 green light-emitting diode EDmg2 may include the sub-pixel electrode 210, the emission layer 220, and the opposite electrode 230. The 1-2 green light-emitting diode EDmg2 may be driven by the first sub-pixel circuit PCm located therebelow.

The second connection line CNL2 may include the first portion CNL2a on the third interlayer insulating layer 116, the second portion CNL2b and the connection electrode CM on the first organic insulating layer 121, and the third portion CNL2c on the second organic insulating layer 123. The first portions CNL2a of the second connection line CNL2 may be arranged on the same layer as a third connection electrode NM3 of the first sub-pixel circuit PCm and the first sub-portion HNLa of the horizontal conductive line HNL' and may include the same material as the third connection electrode NM3 of the first sub-pixel circuit PCm and the first sub-portion HNLa of the horizontal conductive line HNL'.

The connection electrode 190' may be electrically connected to the first portion CNL2a through a contact hole of the first organic insulating layer 121. The second portion CNL2b may electrically connect the first portions CNL2a through a contact hole of the first organic insulating layer 121. The connection electrode CM may be electrically connected to the first portion CNL2a through a contact hole of the first organic insulating layer 121. The second portion CNL2b and the connection electrode CM of the second connection line CNL2 may be arranged on the same layer as the connection electrode 190' and the second sub-portion HNLb (see FIG. 11H) of the horizontal conductive line HNL' and may include the same material as the connection electrode 190' and the second sub-portion HNLb of the horizontal conductive line HNL'.

The third portion CNL2c of the second connection line CNL2 may be electrically connected to the sub-pixel electrode 210 of the 3-2 green light-emitting diode EDng2. The third portion CNL2c may be integrally provided with the sub-pixel electrode 210 of the 3-2 green light-emitting diode EDng2. The third portion CNL2c may be arranged on the same layer as the sub-pixel electrode 210 and may include the same material as the sub-pixel electrode 210.

The sub-pixel electrode 210 of the 3-2 green light-emitting diode EDng2 may be electrically connected to the sub-pixel electrode 210 of the 1-2 green light-emitting diode EDmg2 through the second connection line CNL2 and the connection electrode 190'.

In a comparative example, in the case where connection lines electrically connecting the third light-emitting diodes in the intermediate area to the first light-emitting diodes in the main display area are arranged on the same layer as the sub-pixel electrode of the light-emitting diodes and include the same material as the third light-emitting diodes in the intermediate area and the first light-emitting diodes in the main display area, the configuration form of the third light-emitting diode that may be connected to the first light-emitting diode by the connection line may be limited in an aspect of design space limitation.

In contrast, according to some embodiments, the connection lines CNL electrically connecting the third light-emitting diodes EDn in the intermediate area to the first light-emitting diodes EDm in the main display area MDA may include portions located on a layer different from the sub-pixel electrode 210 of the light-emitting diode. As an example, the second connection line CNL2 may include the first portion CNL2a, the second portion CNL2b, and the connection electrode CM below the sub-pixel electrode 210. The second connection line CNL2 may extend in the x direction between the horizontal conductive line HNL and the component area CA and electrically connect the 3-2 green light-emitting diode EDng2 to the 1-2 green light-emitting diode EDmg2 located at a relatively long distance. Accordingly, a limitation in a configuration structure of the third light-emitting diodes EDn in the intermediate area MA may be reduced. As the third light-emitting diodes EDn are arranged in the intermediate area MA in a desired shape, the visibility of the boundary between the component area CA and the main display area MDA may be reduced.

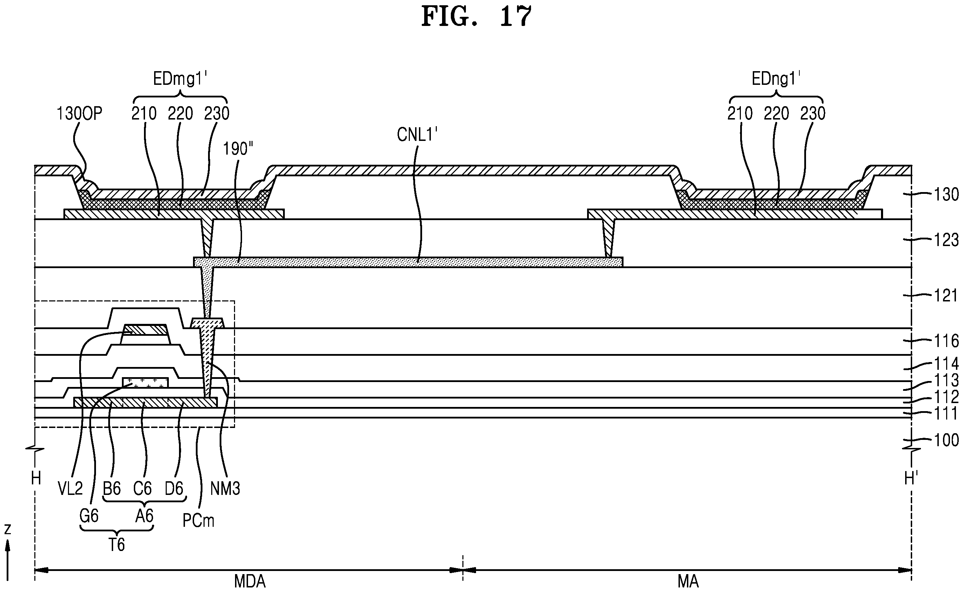

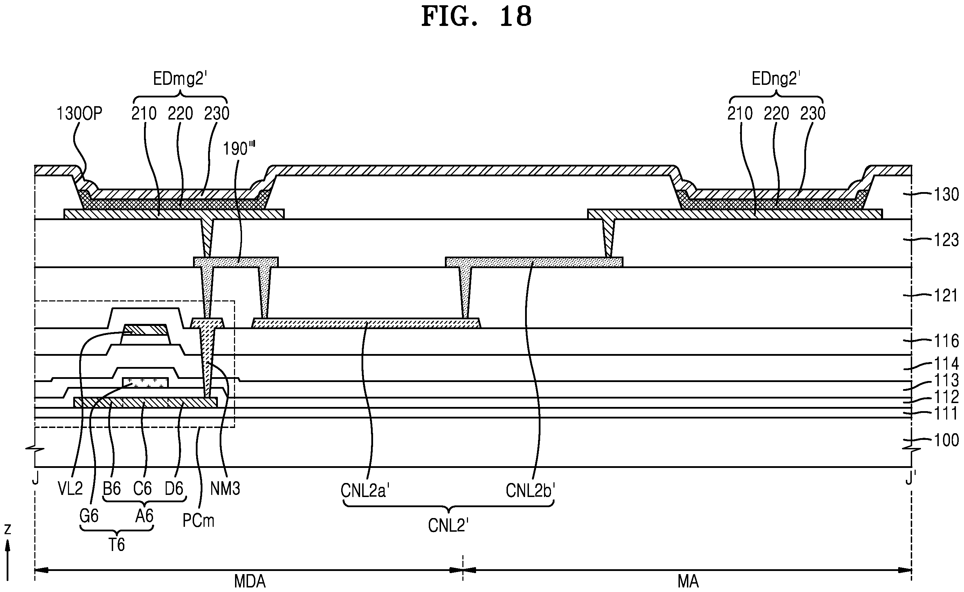

FIG. 16 is a schematic plan view of a portion of the main display area and the intermediate area according to some embodiments. FIG. 17 is a cross-sectional view of the main display area and the intermediate area, taken along the line H-H' of FIG. 16, and FIG. 18 is a cross-sectional view of the main display area and the intermediate area, taken along the line J-J' of FIG. 16.

FIG. 12 shows a connection line electrically connecting the third light-emitting diode EDn in the intermediate area MA to the first light-emitting diode EDm in the main display area MDA, wherein the third light-emitting diode EDn in the intermediate area MA is spaced apart in the x direction from the first light-emitting diode EDm in the main display area MDA, while FIG. 16 shows a connection line electrically connecting the third light-emitting diode EDn in the intermediate area MA to the first light-emitting diode EDm in the main display area MDA, wherein the third light-emitting diode EDn in the intermediate area MA is spaced apart in the y direction from the first light-emitting diode EDm in the main display area MDA. The case of electrically connecting the third green light-emitting diode EDng to the adjacent first green light-emitting diode EDmg through the connection line CNL is described as an example. The same or similar connection line CNL is also applicable to the connection of the third blue light-emitting diode EDnb to the adjacent first blue light-emitting diode EDmb, and the connection of the third red light-emitting diode EDnr to the adjacent first red light-emitting diode EDmr.

Referring to FIGS. 16 and 17, according to some embodiments, the third green light-emitting diodes EDng in the intermediate area MA may include a 3-1 green light-emitting diode EDng1' and a 3-2 green light-emitting diode EDng2'. The first green light-emitting diodes EDmg arranged in the main display area MDA may include a 1-1 green light-emitting diode EDmg1' and a 1-2 green light-emitting diode EDmg2'. According to some embodiments, the connection lines CNL may include a first connection line CNL1' and a second connection line CNL2'.

According to some embodiments, the 3-1 green light-emitting diode EDng1' may be electrically connected to an adjacent 1-1 green light-emitting diode EDmg1' through the first connection line CNL1'. In other words, the sub-pixel electrode 210 of the 3-1 green light-emitting diode EDng1' may be electrically connected to the sub-pixel electrode 210 of the adjacent 1-1 green light-emitting diode EDmg1' through the first connection line CNL1'. The first connection line CNL1' may extend in the y direction.

Referring to FIG. 17, the first sub-pixel circuit PCm located on the substrate 100 may be electrically connected to the sub-pixel electrode 210 of the 1-1 green light-emitting diode EDmg1' through the connection electrode 190" on the first organic insulating layer 121. The 1-1 green light-emitting diode EDmg1' may include the sub-pixel electrode 210, the emission layer 220, and the opposite electrode 230. The 1-1 green light-emitting diode EDmg1' may be driven by the first sub-pixel circuit PCm located therebelow.

The sub-pixel electrode 210 of the 3-1 green light-emitting diode EDng1' may be electrically connected to the 1-1 green light-emitting diode EDmg1 through the first connection line CNL1' on the first organic insulating layer 121.

The first connection line CNL1' may be arranged on the same layer as the connection electrode 190" and may include the same material as the connection electrode 190". The first connection line CNL1' may be integrally provided with the connection electrode 190". The first connection line CNL1' may be electrically connected to the sub-pixel electrode 210 of the 3-1 green light-emitting diode EDng1' through a contact hole of the second organic insulating layer 123.

Referring to FIGS. 16 and 18, the 3-2 green light-emitting diode EDng2' may be electrically connected to the adjacent 1-2 green light-emitting diode EDmg2' through the second connection line CNL2'. In other words, the sub-pixel electrode 210 of the 3-2 green light-emitting diode EDng2' may be electrically connected to the sub-pixel electrode 210 of the adjacent 1-2 green light-emitting diode EDmg2' through the second connection line CNL2'.

According to some embodiments, the second connection line CNL2' may extend in the y direction. According to some embodiments, the second connection line CNL2' may include a first portion CNL2a' and a second portion CNL2b'.

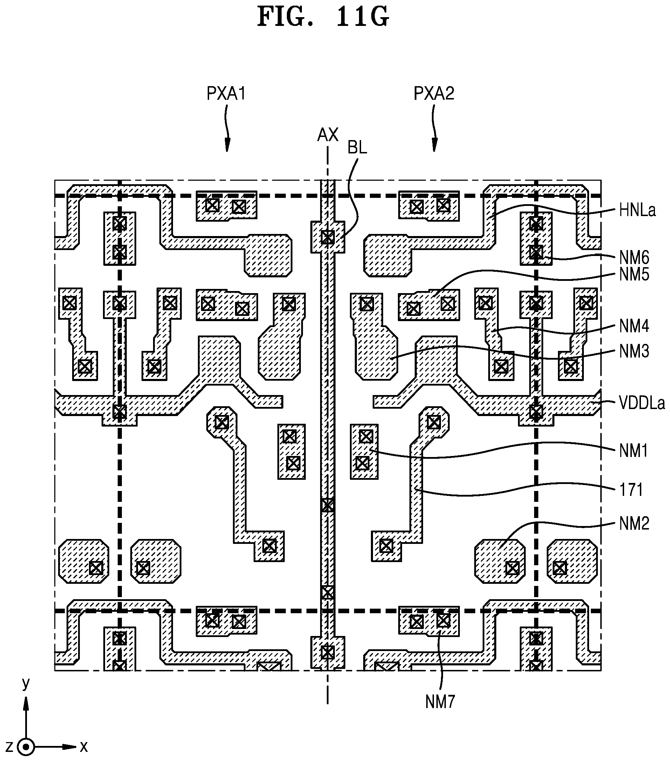

Vertical conductive lines VNL and VNL' may be arranged in the main display area MDA. In this case, the vertical conductive lines VNL and VNL' may correspond to the second vertical conductive line VNL2, for example, a second portion VNL2-2 of the second vertical conductive line VNL2 described with reference to FIG. 8B. According to some embodiments, the vertical conductive lines VNL and VNL' may correspond to the voltage transfer line BL described with reference to FIG. 11G.

According to some embodiments, the second connection line CNL2' may be arranged on the same column as the vertical conductive line VNL'. The second connection line CNL2' may be arranged between the vertical conductive line VNL' and the component area CA. One end the vertical conductive line VNL' may be arranged adjacent to the first portion CNL2a' of the second connection line CNL2'. One end the vertical conductive line VNL' may be spaced apart from and may not be electrically connected to the first portion CNL2a' of the second connection line CNL2'. The first portion CNL2a' of the second connection line CNL2' may be electrically connected to the 1-2 green light-emitting diode EDmg2' through a connection electrode 190‴.

Referring to FIG. 18, the first sub-pixel circuit PCm located on the substrate 100 may be electrically connected to the sub-pixel electrode 210 of the 1-2 green light-emitting diode EDmg2' through the connection electrode 190‴ on the first organic insulating layer 121. The 1-2 green light-emitting diode EDmg2' may include the sub-pixel electrode 210, the emission layer 220, and the opposite electrode 230. The 1-2 green light-emitting diode EDmg2' may be driven by the first sub-pixel circuit PCm located therebelow.

The second connection line CNL2' may include a first portion CNL2a' on the third interlayer insulating layer 116 and a second portion CNL2b' on the first organic insulating layer 121. The first portion CNL2a' of the second connection line CNL2' may be arranged on the same layer as the third connection electrode NM3 of the first sub-pixel circuit PCm and the vertical conductive line VNL' and may include the same material as the third connection electrode NM3 of the first sub-pixel circuit PCm and the vertical conductive line VNL'.

The connection electrode 190‴ may be electrically connected to the first portion CNL2a' through a contact hole of the first organic insulating layer 121. The second portion CNL2b' may be electrically connected to the first portion CNL2a' through a contact hole of the first organic insulating layer 121. The second portion CNL2b of the second connection line CNL2' may be arranged on the same layer as the connection electrode 190‴ and may include the same material as the connection electrode 190‴.

The second portion CNL2b' of the second connection line CNL2' may be electrically connected to the sub-pixel electrode 210 of the 3-2 green light-emitting diode EDng2' through a contact hole of the second organic insulating layer 123.

The sub-pixel electrode 210 of the 3-2 green light-emitting diode EDng2 may be electrically connected to the sub-pixel electrode 210 of the 1-2 green light-emitting diode EDmg2 through the second connection line CNL2 and the connection electrode 190‴.

According to some embodiments, the connection lines CNL electrically connecting the third light-emitting diodes EDn in the intermediate area to the first light-emitting diodes EDm in the main display area MDA may include portions located on a layer different from the sub-pixel electrode 210 of the light-emitting diode. As an example, the second connection line CNL2' may include the first portion CNL2a' and the second portion CNL2b' below the sub-pixel electrode 210. According to some embodiments, the second connection line CNL2' may overlap the sub-pixel electrode 210 of the first red light-emitting diode EDmr arranged between the 3-2 green light-emitting diode EDng2' and the 1-2 green light-emitting diode EDmg2'. The second connection line CNL2 may extend in the y direction between the vertical conductive line VNL' and the component area CA and electrically connect the 3-2 green light-emitting diode EDng2' to the 1-2 green light-emitting diode EDmg2' through a path not detouring around the sub-pixel electrode 210 of the first red light-emitting diode EDmr. Thus, according to some embodiments, a limitation in a configuration structure of the third light-emitting diodes EDn in the intermediate area MA may be reduced. As the third light-emitting diodes EDn are arranged in the intermediate area MA in a desired shape, the visibility of the boundary between the component area CA and the main display area MDA may be reduced.

In the display apparatus according to some embodiments, a brightness deviation around the component area may be relatively improved. However, the scope of embodiments according to the present disclosure is not limited by this effect.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims, and their equivalents.

## Claims

1. A display apparatus comprising:
a substrate including a first area, a second area, and a third area between the first area and the second area;
first light-emitting diodes in the first area;
first sub-pixel circuits in the first area and respectively and electrically connected to the first light-emitting diodes;
second light-emitting diodes in the second area;
second sub-pixel circuits in the second area and respectively and electrically connected to the second light-emitting diodes;
third light-emitting diodes in the third area; and
a connection line electrically connecting a sub-pixel electrode of each of the third light-emitting diodes to a sub-pixel electrode of each of the first light-emitting diodes.

2. The display apparatus of claim 1, wherein the first light-emitting diodes, the second light-emitting diodes, and the third light-emitting diodes respectively include light-emitting diodes configured to emit light of a first color, light-emitting diodes configured to emit light of a second color, and light-emitting diodes configured to emit light of a third color, and
the connection line electrically connects a sub-pixel electrode of a third light-emitting diode configured to emit light of a first color to a sub-pixel electrode of a first light-emitting diode configured to emit light of a first color.

3. The display apparatus of claim 2, wherein the third light-emitting diode configured to emit light of the first color has a same size as the first light-emitting diode configured to emit light of the first color.

4. The display apparatus of any one of claims 1 to 3, further comprising a horizontal conductive line extending in a first direction,
wherein the horizontal conductive line includes:
a first horizontal conductive line spaced apart from the second area in a second direction crossing the first direction; and
a second horizontal conductive line including a first portion and a second portion spaced apart from each other with the second area therebetween, and
wherein the connection line extends in the first direction and is arranged in a same row as the second horizontal conductive line.

5. The display apparatus of claim 4, wherein:
(i) the connection line is between the first portion of the second horizontal conductive line and the second area, or between the second portion of the second horizontal conductive line and the second area; and/or
(ii) the horizontal conductive line is electrically connected to an opposite electrode of the first light-emitting diode.

6. The display apparatus of any one of claims 1 to 5, further comprising a vertical conductive line extending in a second direction,
wherein the vertical conductive line includes: a first vertical conductive line spaced apart from the second area in a first direction crossing the second direction; and
a second vertical conductive line including a first portion and a second portion spaced apart from each other with the second area therebetween, and
wherein the connection line extends in the second direction and is in a same column as the second vertical conductive line.

7. The display apparatus of claim 6, wherein:
(i) the connection line extends in the second direction and is between the first portion of the second vertical conductive line and the second area, or between the second portion of the second vertical conductive line and the second area; and/or
(ii) the vertical conductive line is electrically connected to an opposite electrode of the first light-emitting diode.

8. The display apparatus of any one of claims 4 to 7, wherein the horizontal conductive line includes a first sub-portion and a second sub-portion, and the second sub-portion of the horizontal conductive line is on a layer different from a layer on which the first sub-portion is located.

9. The display apparatus of claim 8, wherein the connection line includes a first portion and a second portion on different layers,
wherein the first portion of the connection line includes a same material as the first sub-portion of the horizontal conductive line, and
wherein the second portion of the connection line includes a same material as the second sub-portion of the horizontal conductive line.

10. The display apparatus of claim 9, wherein the first sub-pixel circuit includes:
a first transistor including a first semiconductor layer and a first gate electrode overlapping a channel region of the first semiconductor layer; and
a first electrode overlapping and electrically connected to one of a source region and a drain region of the first semiconductor layer.

11. The display apparatus of claim 10, wherein the first portion of the connection line includes a same material as the first electrode.

12. The display apparatus of claim 10 or claim 11, further comprising:
a first insulating layer covering the first electrode; and
a second electrode on the first insulating layer and electrically connecting the first electrode to a sub-pixel electrode of the first light-emitting diode.

13. The display apparatus of claim 12, wherein:
(i) the second portion of the connection line includes a same material as the second electrode; and/or
(ii) the connection line further includes a third portion on a layer different from the first portion and the second portion, and wherein the third portion of the connection line includes a same material as a sub-pixel electrode of the first light-emitting diode.

14. The display apparatus of any one of claims 10 to 13, wherein the first sub-pixel circuit further includes a second transistor including a second semiconductor layer and a second gate electrode overlapping the second semiconductor layer,
wherein the first semiconductor layer of the first transistor includes a silicon semiconductor material, and
wherein the second semiconductor layer of the second transistor includes an oxide semiconductor material.

15. The display apparatus of any one of claims 1 to 14, wherein:
(i) the second area includes a transmission area; and/or
(ii) the display apparatus further comprises a component overlapping the second area, optionally wherein the component includes a camera or a sensor.
